(19) Europäisches Patentamt / European Patent Office / Office européen des brevets

(11) **EP 4 750 236 A1**

(12) **EUROPEAN PATENT APPLICATION**
published in accordance with Art. 153(4) EPC

(43) Date of publication:
**27.05.2026 Bulletin 2026/22**

(21) Application number: **24856232.4**

(22) Date of filing: **30.07.2024**

(51) International Patent Classification (IPC):
**H05K 7/20** (2006.01)    **F28F 1/18** (2006.01)

(52) Cooperative Patent Classification (CPC):
**F28F 1/18; H05K 7/20**

(86) International application number:
**PCT/JP2024/027140**

(87) International publication number:
**WO 2025/041539 (27.02.2025 Gazette 2025/09)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.08.2023  JP 2023136107**
**24.08.2023  JP 2023136205**

(71) Applicant: **JVCKenwood Corporation**
**Yokohama-shi, Kanagawa 2210022 (JP)**

(72) Inventors:
• **INAGAKI, Kazuyuki**
**Yokohama-shi, Kanagawa 221-0022 (JP)**
• **NARITA, Yoko**
**Yokohama-shi, Kanagawa 221-0022 (JP)**

(74) Representative: **Wagner & Geyer**
**Partnerschaft mbB**
**Patent- und Rechtsanwälte**
**Gewürzmühlstrasse 5**
**80538 München (DE)**

(54) **HEAT SINK AND ELECTRONIC APPARATUS**

(57) An objective is to enhance the cooling effect. A heat sink 1 includes: a base 2 having a plate-like one surface 21a attached along the outer surface of a right plate 102f representing an upright wall portion of a main body unit 102 of an electronic device 101; a plurality of fins 3 arranged side by side along a plate-like other surface 21b of the base 2; and passage portions 4 that are formed in between the fins 3 and in a continuous manner along the other surface 21b of the base 2. In the state in which the base 2 is attached to the right plate 102f, the fins 3 are formed in such a way that the one end portions 4a of the passage portions 4 are left open toward the lower side along the vertical direction and that the other end portions 4b of all passage portions 4 are positioned on the upper side with respect to the one end portions 4a and are left open along the horizontal direction.

FIG.3

# EP 4 750 236 A1

## Description

Field

The present invention relates to a heat sink and an electronic device.

Background

For example, in Patent Literature 1, a heat sink is disclosed. In that heat sink, regardless of whether one side of the fin base is extended along the horizontal direction or the vertical direction, the objective is to hold down a decline in the amount of heat exchange occurring between the air present in the gaps present among the fins and the surfaces of the fins. For that reason, the heat sink has a square-shaped heat base or a rectangular heat base that includes: a first surface that is connected to a heating element; a second surface present on the opposite side of the first surface with respect to the side toward the heating element; a first side that extends in the horizontal direction or the vertical direction; a second side that has one end thereof connected to one end of the first side; a third side that has one end thereof connected to the other end of the first side; and a fourth side that has one end thereof connected to the other end of the second side and that has the other end thereof connected to the other end of the third side. Moreover, the heat sink has a plurality of fins that are disposed on the second surface and away from each other and that extend from the first side toward the second side.

Citation List

Patent Literature

[Patent Literature 1] Japanese Patent Application Laid-open No. 2019-092337

Summary

Technical Problem

Meanwhile, for example, an electronic device is known that functions as an in-vehicle device and that is fixed inside the dashboard of a vehicle using metal fittings. Moreover, for example, an electronic device is known that is placed on a shelf. In such an electronic device, sometimes a heat sink that is meant for cooling purposes is disposed on the outer surface of an upright wall portion of that electronic device. Regarding a commonly-used heat sink, one surface of the plate-like base is attached to the outer surface of an upright wall portion, and linear fins are arranged side by side on the other surface of the base present on the opposite side of the one surface. In the case of performing cooling using such a heat sink, in order to achieve cooling in an efficient manner, it is desirable to have the fins extended in the up-down direction and to ensure that, between any two fins, the buoyancy of the air heated due to the heat transferred to the fins facilitates an upward push.

However, as explained above, regarding an electronic device that functions as an in-vehicle device and that is fixed inside the dashboard of a vehicle or regarding an electronic device that is placed on a shelf, since the dashboard has the top panel present on the upper side or since the shelf has the shelf board present on the upper side, the heat that is liberated toward the upper side builds up in between the gaps present in the top panel or in the shelf board and becomes unbale to escape, thereby likely causing a decline in the cooling efficiency.

Herein, for example, even when the heat sink disclosed in Patent Literature 1 is disposed on the outer surface of an upright wall portion of an electronic device, because of its intended characteristic configuration, there is a possibility that the heat released toward the upper side builds up in between the gaps present in the top panel or the shelf board, as is the case in a commonly-used heat sink.

It is an objective of the application concerned to provide a heat sink and an electronic device that enable prevention of a situation in which the heat builds up in the gaps present on the upper side of the electronic device and enable achieving enhancement in the cooling efficiency.

A heat sink according to the present disclosure comprising: a base that has a plate-like one surface attached to outer surface of an upright wall portion of an electronic device; a plurality of fins arranged side by side along a plate-like other surface of the base; and passage portions that are formed in between the fins and in a continuous manner along the other surface of the base, wherein in a state in which the base is attached to the upright wall portion, the fins are formed in such a way that one end portions of the passage portions are left open toward lower side along vertical direction and that other end portions of all of the passage portions are positioned on upper side with respect to the one end portions and are left open along horizontal direction.

An electronic device according to the present disclosure utilize the heat sink.

**EP 4 750 236 A1**

According to the application concerned, it becomes possible to achieve enhancement in the cooling efficiency.

Brief Description of Drawings

FIG. 1 is a perspective view of an electronic device in which a heat sink according to an embodiment is used.
FIG. 2 is a perspective view of the heat sink according to a first embodiment.
FIG. 3 is a side view of the heat sink according to the first embodiment.
FIG. 4 is a perspective view of the action of the heat sink according to the first embodiment.
FIG. 5 is a perspective view of the action of a commonly-used heat sink.
FIG. 6 is a perspective view of the action of a commonly-used heat sink.
FIG. 7 is a side view of another example of the heat sink according to the first embodiment.
FIG. 8 is a side view of another example of the heat sink according to the first embodiment.
FIG. 9 is a side view of another example of the heat sink according to the first embodiment.
FIG. 10 is a side view of another example of the heat sink according to the first embodiment.
FIG. 11 is an explanatory diagram for explaining a thermal boundary layer.
FIG. 12 is a side view of another example of the heat sink according to the first embodiment.
FIG. 13 is a side view of another example of the heat sink according to the first embodiment.
FIG. 14 is a side view of another example of the heat sink according to the first embodiment.
FIG. 15 is a side view of another example of the heat sink according to the first embodiment.
FIG. 16 is a side view of another example of the heat sink according to the first embodiment.
FIG. 17 is a side view of a heat sink according to a second embodiment.
FIG. 18 is a side view of another example of the heat sink according to the second embodiment.
FIG. 19 is a side view of another example of the heat sink according to the second embodiment.
FIG. 20 is a side view of another example of the heat sink according to the second embodiment.
FIG. 21 is a side view of another example of a heat sink according to a third embodiment.
FIG. 22 is a side view of a model 1 of a heat sink according to a working example.
FIG. 23 is a perspective view of the model 1 of a heat sink according to a working example.
FIG. 24 is an analysis diagram of the model 1 of a heat sink according to a working example.
FIG. 25 is an analysis diagram of the model 1 of a heat sink according to a working example.
FIG. 26 is a side view of a model 2 of a heat sink according to the working example.
FIG. 27 is a perspective view of the model 2 of a heat sink according to the working example.
FIG. 28 is an analysis diagram of the model 2 of a heat sink according to a working example.
FIG. 29 is an analysis diagram of the model 2 of a heat sink according to a working example.
FIG. 30 is a side view of a model 3 of a heat sink according to the working example.
FIG. 31 is a perspective view of the model 3 of a heat sink according to the working example.
FIG. 32 is an analysis diagram of the model 3 of a heat sink according to a working example.
FIG. 33 is an analysis diagram of the model 3 of a heat sink according to a working example.
FIG. 34 is a side view of a model 4 of a heat sink according to the working example.
FIG. 35 is a perspective view of the model 4 of a heat sink according to the working example.
FIG. 36 is an analysis diagram of the model 4 of a heat sink according to a working example.
FIG. 37 is an analysis diagram of the model 4 of a heat sink according to a working example.
FIG. 38 is a side view of a model 5 of a heat sink according to the working example.
FIG. 39 is a perspective view of the model 5 of a heat sink according to the working example.
FIG. 40 is an analysis diagram of the model 5 of a heat sink according to a working example.
FIG. 41 is a chart illustrating the result of a performance test of heat sinks according to the working example.
FIG. 42 is a chart illustrating the evaluation of each model subjected to the performance test of heat sinks according to the working example.

Description of Embodiments

An illustrative embodiment (hereinafter, called an embodiment) according to the application concerned is described in detail with reference to the accompanying drawings. However, the application concerned is not limited by the embodiment described below. Moreover, the constituent elements described below in the embodiment are to be construed as embodying all modifications and alternative constructions that may occur to one skilled in the art that fairly fall within the basic teaching herein set forth. Furthermore, the constituent elements described below in the embodiment can be combined in an appropriate manner.

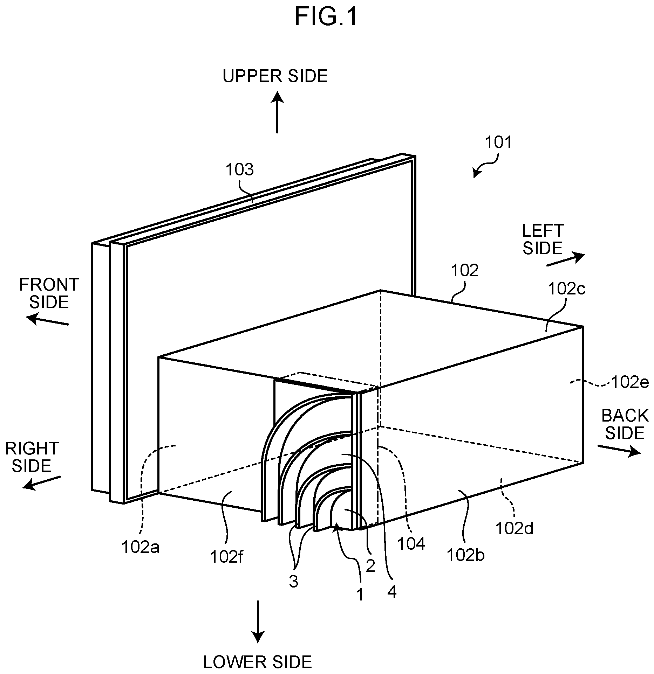

FIG. 1 is a perspective view of an electronic device in which a heat sink according to the embodiment is used. An electronic device 101 according to the present embodiment is, for example, an AV (Audio Visual) integrated-type car navigation device installed inside a vehicle. Moreover, the electronic device according to the present embodiment can be an electronic device placed on a shelf.

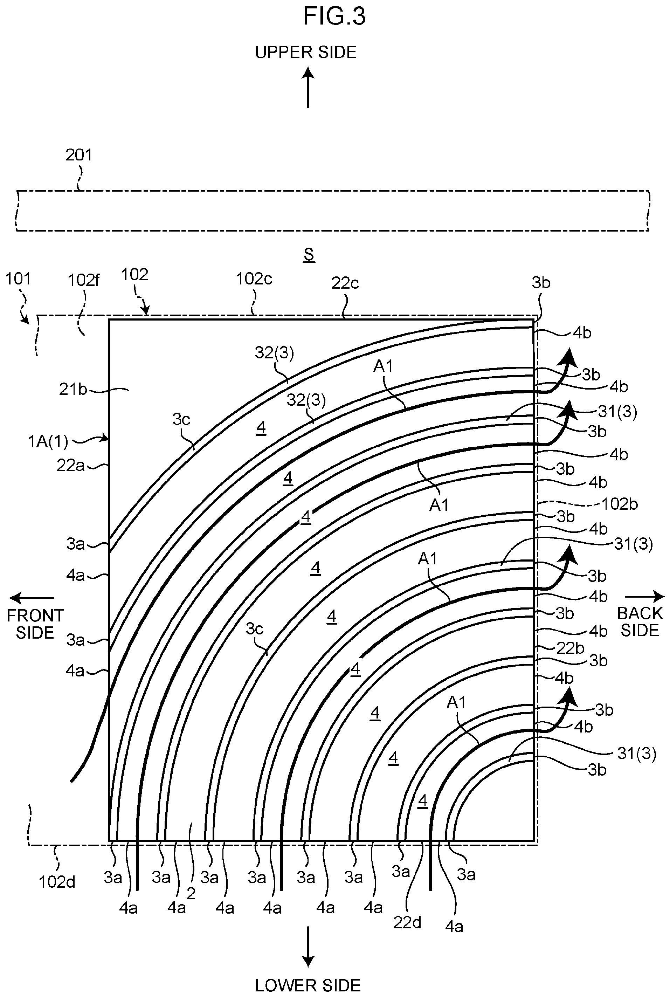

In the following explanation, the front side represents the surface seen by the operator, and corresponds to the front side of the electronic device 101 illustrated in FIGS. 1 and 3. In the case of a car navigation device, since the electronic device 101 is placed in the front on the inside of the vehicle, the side facing toward the back side of the vehicle serves as the front side. Moreover, in the present embodiment, regarding the explanation of an electronic device and a display panel storage structure; the upper side, the lower side, the right side, the left side are set with reference to the state seen from the front side, and the opposite side of the front side represents the back side.

As illustrated in FIG. 1, the electronic device 101 according to the present embodiment includes a main body unit 102, a display unit 103, and a heating element 104.

The main body unit 102 has a structure in which the front side, the upper side, the lower side, the right side, the left side, and the back side are covered by metal plates. Accordingly, the main body unit 102 includes a front plate 102a, a back plate 102b, an upper plate 102c, a lower plate 102d, a left plate 102e, and a right plate 102f that represent external housing members constituting the external casing; and is formed to have an overall cuboid shape. The main body unit 102 is placed inside a center cluster (also called a dashboard) 201 illustrated in FIG. 3, and is fixed with screws using metal fittings (not illustrated). The center cluster 201 is configured as a plate member.

In the state in which the main body unit 102 is fixed inside the center cluster 201; the front plate 102a, the back plate 102b, the left plate 102e, and the right plate 102f are configured as upright wall portions along the vertical direction (the up-down direction), and the upper plate 102c and the lower plate 102d are configured as lateral wall portions connected to the upper and lower ends of the upright wall portions. The upper plate 102c is configured as an upper lateral wall portion connected to the upper end of the upright wall portions, and the lower plate 102d is configured as a lower lateral wall portion connected to the lower end of the upright wall portions.

Thus, as illustrated in FIG. 3, in the state in which the main body unit 102 is fixed inside the center cluster 201 representing a plate member, the center cluster 201 is placed above the upper plate 102c, which is the upper lateral wall portion, with a gap S maintained therebetween. Moreover, as illustrated in FIG. 3, the back side of the main body unit 102 is an open region. The structure of the center cluster 201 is such that the main body unit 102 is enveloped therein. Meanwhile, in the drawings, only some part of the center cluster 201 that is placed above the main body unit 102 is illustrated as a flat plate in a simplified manner.

The display unit 103 is installed on the front side of the main body unit 102, with the panel thereof, which represents the display surface, oriented toward the front side. The display unit 103 includes, for example, a liquid crystal display (LCD) or an organic EL (organic Electro-Luminescence) display. Although not explicitly illustrated in the drawings, the display unit 103 is configured as a touch-sensitive panel. When the main body unit 102 is placed inside the center cluster 201, the display unit 103 is placed to be visible from the outside of the center cluster 201.

The heating element 104 is disposed inside the main body unit 102. For example, the heating element 104 is a control device that controls the electronic device 101. The heating element 104 is fixed to an upright wall portion. In the embodiment, the heating element 104 is fixed to the portion that has a flat mounting surface along the outer surface of the right plate 102f representing an upright wall portion and that is formed as a notch in the right plate 102f.

The heat sink 1 according to the embodiment is attached to the outer surface of the right plate 102f that represents the upright wall portion to which the heating element 104 is fixed. The heat sink 1 is fixed to be in contact with the heating element 104. The heat sink 1 is made of a metal. It is desirable that the heat sink 1 is made of a metal such as an aluminum alloy or copper that has relatively high thermal conductivity. Meanwhile, in the electronic device 101 in which the heating element 104 is disposed, it is common practice that the power supply cord and connectors for establishing connection with other devices are disposed on the back plate 102b representing the back side of the main body unit 102. Hence, sometimes a radiator cannot be disposed on the back plate 102b. For that reason, in the embodiment, the heating element 104 is disposed along the right plate 102f while avoiding the back plate 102b, and the heat sink 1 is fixed to be in contact with the mounting surface of the heating element 104.

[First embodiment of heat sink]

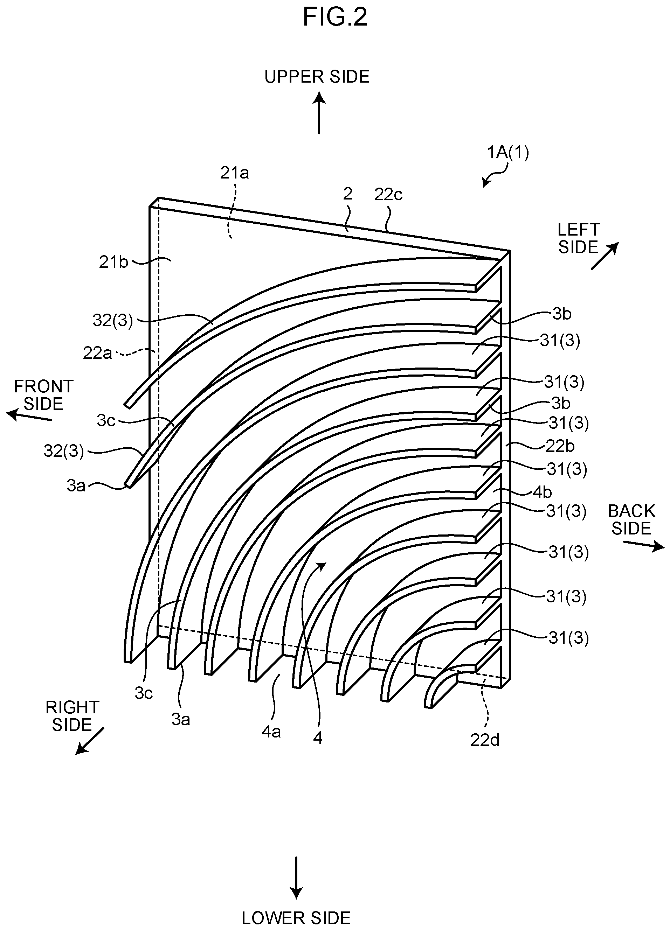

Regarding the heat sink 1 according to a first embodiment, the detailed explanation is given below with reference to FIGS. 2 to 4. In each drawing, it is illustrated that the heat sink 1 is attached to the right plate 102f representing an upright wall portion.

A heat sink 1A illustrated in FIGS. 2 to 4 includes a base 2, fins 3, and passage portions 4.

The base 2 is formed in the shape of a plate. The base 2 includes a plate-shaped one surface 21a and a plate-shaped other surface 21b. In the drawings, the one surface 21a is illustrated to be facing the left side, and the other surface 21b is illustrated to be facing the right side. The base 2 of the heat sink 1A has the one surface 21a and the other surface 21b formed in a rectangular shape, and includes four ends (edges). More particularly, with reference to the drawings, the base 2 includes an anterior end (an anterior edge) 22a facing the front side, a posterior end (a posterior edge) 22b facing the back side, an upper end (an upper edge) 22c facing the upper side, and a lower end (a lower edge) 22d facing the lower side. The base 2 is attached to the mounting surface that appears in the notch formed on the right plate 102f representing an upright wall portion. The base 2 is attached in such a way the one surface 21a is in contact with the mounting surface of the heating element 104. In the base 2, the one surface 21a has a greater area than the area of the mounting surface of the heating element 104.

The fins 3 are disposed on the other surface 21b of the base 2. Thus, the fins 3 are disposed on the other surface 21b that, in the base 2, faces the opposite side of the right plate 102f representing an upright wall portion to which the heating element 104 is fixed. In the heat sink 1A, the fins 3 include first-type fins 31 and second-type fins 32.

The first-type fins 31 are formed in the shape of a plate and are disposed in an upright manner from the other surface 21b. In the drawings, the first-type fins 31 are placed to extend toward the right side to move away from the other surface 21b of the base 2. Each first-type fin 31 is formed along the other surface 21b of the base 2 and in a continuous manner from a one end portion 3a to another end portion 3b thereof. The one end portion 3a faces toward the lower side. The other end portion 3b faces toward the back side. Thus, each first-type fin 31 is formed in a continuous manner from the lower side to the back side. In each first-type fin 31, the one end portion 3a is placed at the lower end 22d of the base 2, and the other end portion 3b is placed at the posterior end 22b of the base 2. Moreover, in each first-type fin 31, an end edge 3c that stands upright from the other surface 21b of the base 2 ranges from the one end portion 3a to the other end portion 3b at an equal distance from the other surface 21b of the base 2. That is, when expanded, the first-type fin 31 has the shape of a rectangular long plate and, with one end of the long plate serving as the one end portion 3a and the other end of the long plate serving as the other end portion 3b, is fixed to the other surface 21b of the base 2. Moreover, each first-type fin 31 is formed in a curved manner in such a way that the portion between the one end portion 3a and the other end portion 3b bulges upward. In the embodiment, the first-type fins 31 are curved in the shape of an arc so that the portion between the one end portion 3a and the other end portion 3b bulges upward. Along the other surface 21b of the base 2, the first-type fins 31 are arranged side by side with intervals maintained therebetween. Between the neighboring first-type fins 31, the interval along the other surface 21b of the base 2 is uniformly equal ranging from the one end portions 3a to the other end portions 3b.

The second-type fins 32 are placed on the outside of the curvature of the first-type fins 31. The second-type fins 32 are formed in the shape of a plate and are disposed in an upright manner from the other surface 21b of the base 2. With reference to the drawings, the second-type fins 32 are placed to extend toward the right side to move away from the other surface 21b of the base 2. Each second-type fin 32 is formed along the other surface 21b of the base 2 and in a continuous manner from the one end portion 3a to the other end portion 3b thereof. The one end portion 3a faces toward the front side. The other end portion 3b faces toward the back side. Thus, each second-type fin 32 is formed in a continuous manner from the front side to the back side. In each second-type fin 32, the one end portion 3a is placed at the front end 22a of the base 2, and the other end portion 3b is placed at the posterior end 22b of the base 2. Moreover, in each second-type fin 32, the end edge 3c that stands upright from the other surface 21b of the base 2 ranges from the one end portion 3a to the other end portion 3b at an equal distance from the other surface 21b of the base 2. That is, when expanded, the second-type fin 32 has the shape of a rectangular long plate and, with one end of the long plate serving as the one end portion 3a and the other end of the long plate serving as the other end portion 3b, is fixed to the other surface 21b of the base 2. Moreover, each second-type fin 32 is formed in a curved manner in such a way that the portion between the one end portion 3a and the other end portion 3b bulges upward. In the embodiment, the second-type fins 32 are curved in the shape of an arc so that the portion between the one end portion 3a and the other end portion 3b bulges upward. Along with the first-type fins 31, the second-type fins 32 are arranged along the other surface 21b of the base 2 and are arranged side by side with intervals maintained therebetween. Between the neighboring second-type fins 32 along the other surface 21b of the base 2, the interval is equal ranging from the one end portion 3a to the other end portion 3b. Meanwhile, the second-type fins 32 need not be included as a mandatory configuration.

In the spaces formed between the first-type fins 31 and the second-type fins 32 neighboring along the other surface 21b of the base 2, the passage portions 4 are formed in a continuous manner along the other surface 21b of the base 2. The passage portions 4 are formed to be open toward the right side in the drawings at the positions of the end edges 3c standing upright from the other surface 21b of the base 2.

The passage portions 4 present in between the first-type fins 31 are formed along the other surface 21b of the base 2 and in a continuous manner from corresponding one end portions 4a to corresponding other end portions 4b. In each passage portion 4, the one end portion 4a is left open at the positions of the one end portions 3a of the corresponding first-type fins 31, and the other end portion 4b is left open at the positions of the other end portions 3b of the corresponding first-type fins 31. The one end portion 4a is left open toward the lower side along the vertical direction. The other end portion 4b is left open toward the back side along the horizontal direction. Accordingly, each passage portion 4 that is positioned in between the first-type fins 31 is formed in a continuous manner from the lower side to the back side in the portion between the one end portion 4a to the other end portion 4b. In the passage portions 4 that are positioned in between the first-type fins 31, the one end portions 4a are left open at the lower end 22d of the base 2, and the other end portions 4b are left open at the posterior end 22b of the base 2. Moreover, since the end edges 3c of the first-type fins 31 range from the corresponding one end portions 3a to the corresponding other end portions 3b at an equal distance from the other surface 21b of the base 2, in the passage portions 4 that are positioned in between the first-type fins 31, the portions from the corresponding one end portions 4a to the corresponding other end portions 4b remain continuous at an equal distance from the other surface 21b of the base 2. Furthermore, since the first-type fins 31 are formed in a curved manner in such a way that the portions between the corresponding one end portions 3a and the corresponding other end portions 3b bulge upward, the passage portions 4 that are positioned in between the first-type fins 31 are formed in a curved manner in such a way that the portions between the corresponding one end portions 4a and the corresponding other end portions 4b bulge upward. Herein, the curvature is formed in the shape of an arc. Thus, The passage portions 4 that are present in between the first-type fins 31 have a uniformly equal interval ranging from the corresponding one end portions 4a to the corresponding other end portions 4b.

Each passage portion 4 corresponding to the second-type fins 32 is formed in a continuous manner from the one end portion 4a to the other end portion 4b along the other surface 21b of the base 2. In each passage portion 4, the one end portion 4a is left open at the positions of the one end portions 3a of the corresponding second-type fins 32, and the other end portion 4b is left open at the positions of the other end portions 3b of the corresponding second-type fins 32. Since the second-type fins 32 and the first-type fins 31 are formed in a curved manner, the one end portions 4a are left open toward the lower side and the front side along the vertical direction. The other end portions 4b are left open toward the back side along the horizontal direction. Accordingly, in each passage portion 4 corresponding to the second-type fins 32, the portion from the one end portion 4a to the other end portion 4b is formed in a continuous manner from the lower side and the front side to the back side. Thus, in each passage portion 4 corresponding to the second-type fins 32, the one end portion 4a is left open at the front end 22a of the base 2, and the other end portion 4b is left open at the posterior end 22b of the base 2. Moreover, since the end edges 3c of the second-type fins 32 range from the corresponding one end portions 3a to the corresponding other end portions 3b at an equal distance from the other surface 21b of the base 2, in the passage portions 4 corresponding to the second-type fins 32, the portions from the corresponding one end portions 4a to the corresponding other end portions 4b remain continuous at an equal distance from the other surface 21b of the base 2. Furthermore, since the second-type fins 32 are formed in a curved manner in such a way that the portions between the corresponding one end portions 3a and the corresponding other end portions 3b bulge upward, the passage portions 4 corresponding to the second-type fins 32 are formed in a curved manner in such a way that the portions between the corresponding one end portions 4a and the corresponding other end portions 4b bulge upward. Herein, the curvature is formed in the shape of an arc. Meanwhile, the passage portions 4 corresponding to the second-type fins 32 need not be included as a mandatory configuration.

As illustrated in FIG. 3, the heat sink 1A configured in the manner explained above has its base 2 fixed to the outer surface of the right plate 102f, which represents an upright wall portion of the main body unit 102 of the electronic device 101. More particularly, in the heat sink 1A, the posterior end 22b of the base 2 is fixed at a position that is at the posterior end of the right plate 102f of the main body unit 102 of the electronic device 101 and that is along the back plate 102b. Then, the electronic device 101, to which the heat sink 1A is fixed, is fixed inside the center cluster 201, which represents a plate member, in a state in which the center cluster 201 is placed above the upper plate 102c of the main body unit 102 with the gap S maintained therebetween.

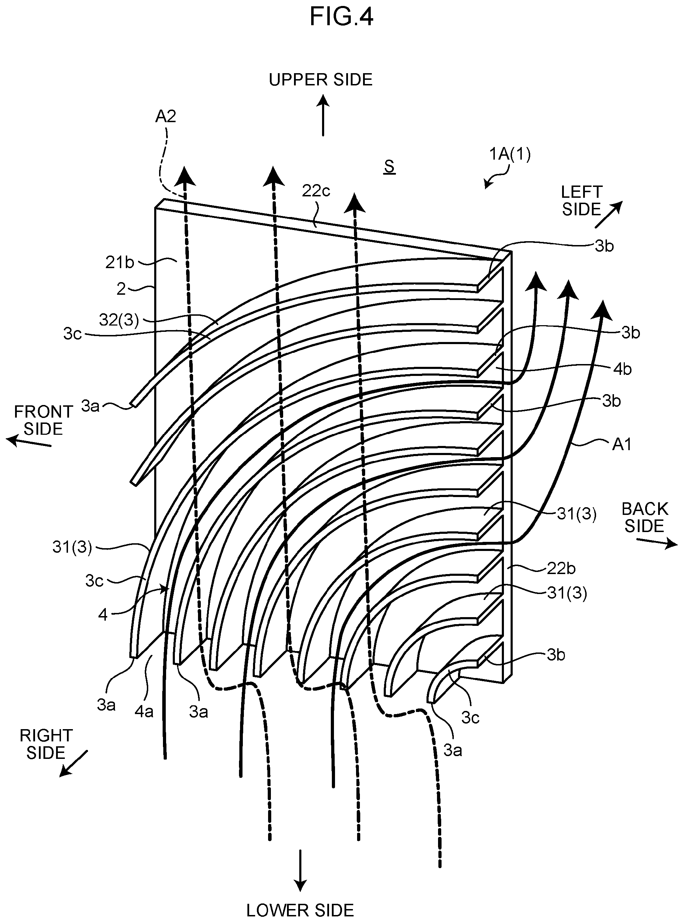

In the heat sink 1A, the heat generated by the heating element 104 of the electronic device 101 is transferred to the base 2 and is then transferred from the base 2 to the fins 3. As illustrated in FIGS. 3 and 4, in the heat sink 1A, due to the heat transferred to the fins 3, air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101.

As illustrated in FIG. 4, in the heat sink 1A, on the outside (in the embodiment, on the right side) of the fins 3, since the surrounding of the heat sink 1A gets heated, there occurs a flow of air A2 which moves upward from the lower side to the upper side. As explained earlier, in the heat sink 1A, since the air A1 flows from the one end portions 4a, which are positioned on the lower side, toward the other end portions 4b, which are positioned on the upper side; at the positions of the one end portions 4a on the lower side, the flow is assisted by getting the air A2 involved. On the other hand, as explained earlier, since the air A1 is liberated to the back side toward which the other end portion 4b is oriented, a flow is created in a different direction than the air A2, thereby holding down the upward flow of the amount of air equivalent to the air A1. For that reason, the heat sink 1A enables holding down the amount of heat release into the gap S present above the center cluster 201 that represents a plate member present above the main body unit 102 of the electronic device 101, and enables the heat release into the open region on the back side of the main body unit 102. As a result, the heat sink 1A enables preventing a situation in which the heat builds up in the gap S present above the electronic device 101, and enables achieving enhancement in the cooling efficiency.

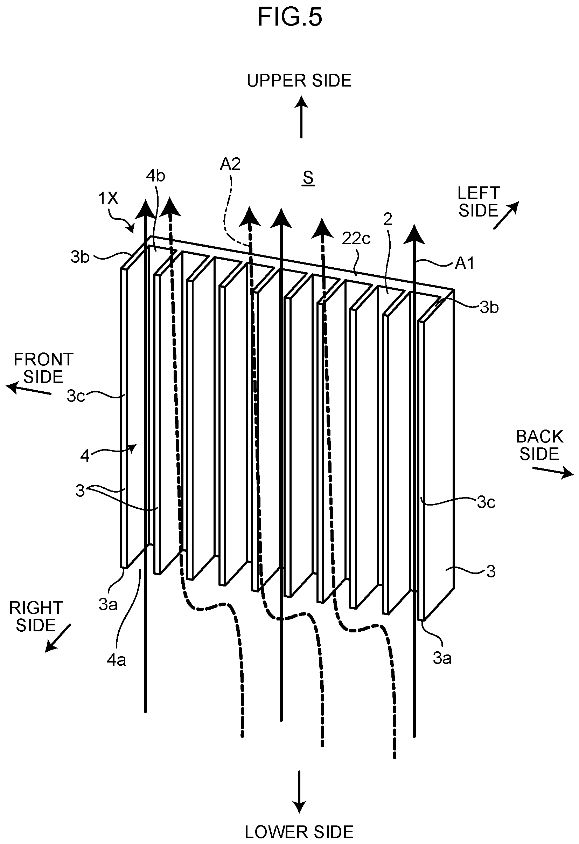

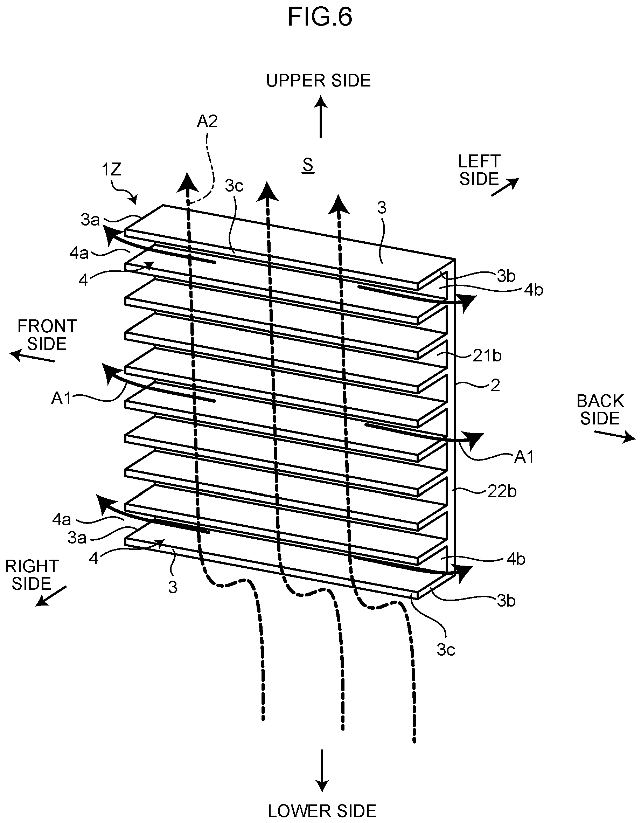

In FIGS. 5 and 6 are illustrated commonly-used heat sinks 1X and 1Z, respectively. The heat sinks 1X and 1Z differ from the heat sink 1A in terms of the shape of the fins 3. In the following explanation, equivalent constituent elements are referred to by the same reference numerals, and their explanation is not given in a repeated manner.

In the heat sinks 1X and 1Z, straight fins 3 are arranged side by side at uniformly equal intervals on the rectangular base 2. The heat sink 1X illustrated in FIG. 5 is fixed to an electronic device in such a way that the fins 3 are positioned along the vertical direction. The heat sink 1Z illustrated in FIG. 6 is fixed to an electronic device in such a way that the fins 3 are positioned along the horizontal direction.

In the heat sink 1X illustrated in FIG. 5, due to the heat transferred to the fins 3, in the passage portions 4 formed in between the fins 3, the air A1 moves upward and flows from the one end portions 4a, which are positioned on the lower side, toward the other end portions 4b, which are positioned on the upper side, and is liberated to the upper side toward which the other end portions 4b are oriented. In the heat sink 1X, on the outside (in the embodiment, on the right side) of the fins 3, due to the heat transferred to the fins 3, there occurs a flow of the air A2 which moves upward from the lower side to the upper side. In the heat sink 1X, since the air A1 flows from the one end portions 4a, which are positioned on the lower side, toward the other end portions 4b, which are positioned on the upper side; at the positions of the one end portions 4a on the lower side and the positions of the other end portions 4b on the upper side, the flow is assisted by getting the air A2 involved. For that reason, the heat sink 1X cannot hold down the amount of heat release into the gap S present above the center cluster 201 that represents a plate member present above the main body unit 102 of the electronic device 101. As a result, the heat sink 1X lets the heat to build up in the gap S present above the electronic device 101, and does not enable achieving enhancement in the cooling efficiency.

In the heat sink 1Z illustrated in FIG. 6, due to the heat transferred to the fin 3, the air A1 that is present in the passage portions 4 formed in between the fins 3 flows toward the one end portions 4a and the other end portions 4b positioned in an anteroposterior manner, and gets liberated from the one end portions 4a and the other end portions 4b in the anteroposterior directions. In the heat sink 1Z, on the outside (in the embodiment, on the right side) of the fins 3, due to the heat transferred to the fins 3, there occurs a flow of the air A2 which moves upward from the lower side to the upper side. In the heat sink 1Z, since the air A1 flows in the anteroposterior direction, there is less action of getting the air A2 involved. For that reason, although the heat sink 1Z enables holding down the amount of heat release into the gap S present above the center cluster 201 that represents a plate member present above the main body unit 102 of the electronic device 101, the direction in which the air A1 is to be liberated remains undecided. As a result, although the heat sink 1Z enables holding down a situation in which the heat builds up in the gap S present above the electronic device 101, it does not enable achieving enhancement in the cooling efficiency.

In this way, the heat sink 1A is excellent in terms of enabling preventing a situation in which the heat builds up in the gap S present above the electronic device 101, and enabling achieving enhancement in the cooling efficiency.

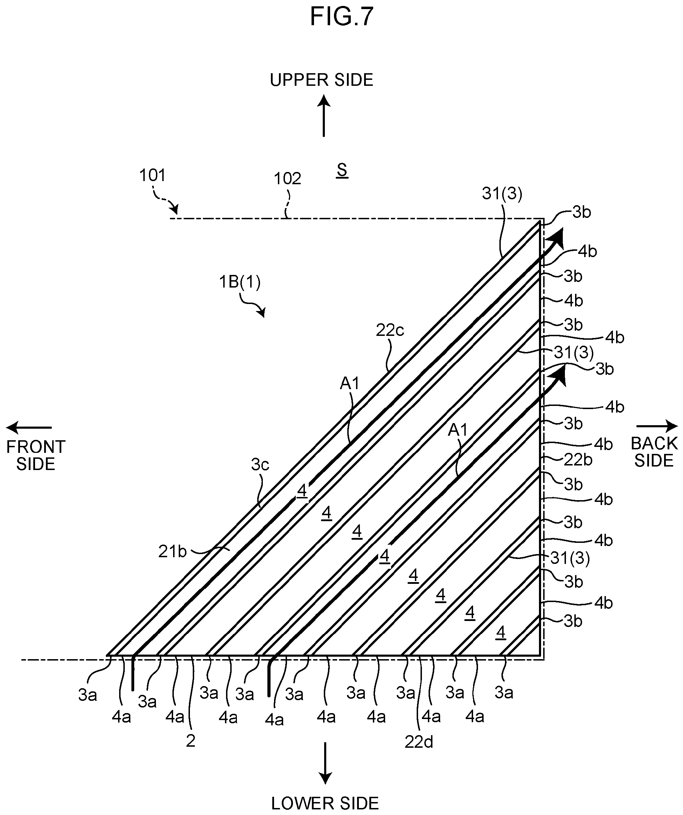

Explained below with reference to FIGS. 7 to 16 are other examples of the heat sink 1 according to the first embodiment. Herein, heat sinks 1B, 1C, 1D, 1E, 1F, 1G, 1H, 1I, and 1N differ from the heat sink 1A mainly in the way of having the fins 3 in a different shape. Thus, equivalent constituent elements are referred to by the same reference numerals, and their explanation is not given in a repeated manner.

The heat sink 1B illustrated in FIG. 7 includes only the first-type fins 31 that are formed in a linear manner.

The first-type fins 31 are formed in a continuous manner from the one end portions 3a to the other end portions 3b along the other surface 21b of the base 2. The one end portions 3a face toward the lower side. The other end portions 3b face toward the back side. The first-type fins 31 are formed in a continuous manner and at an angle from the lower side to the back side. In each first-type fin 31, the one end portion 3a is positioned at the lower end 22d of the base 2, and the other end portion 3b is positioned at the posterior end 22b of the base 2. Moreover, in each first-type fin 31, the end edge 3c that stands upright from the other surface 21b of the base 2 ranges from the one end portion 3a to the other end portion 3b at an equal distance from the other surface 21b of the base 2. That is, the first-type fin 31 has the shape of a rectangular long plate and, with one end of the long plate serving as the one end portion 3a and the other end of the long plate serving as the other end portion 3b, is fixed to the other surface 21b of the base 2. Moreover, each first-type fin 31 is formed in such a way that the portion between the one end portion 3a and the other end portion 3b is linear and at an angle. Along the other surface 21b of the base 2, the first-type fins 31 are arranged side by side with intervals maintained therebetween. Between the neighboring first-type fins 31, the interval along the other surface 21b of the base 2 is uniformly equal ranging from the one end portions 3a to the other end portions 3b.

The passage portions 4 present in between the first-type fins 31 are formed along the other surface 21b of the base 2 and in a continuous manner from the corresponding one end portions 4a to the corresponding other end portions 4b. In each passage portion 4, the one end portion 4a is left open at the positions of the one end portions 3a of the corresponding first-type fins 31, and the other end portion 4b is left open at the positions of the other end portions 3b of the corresponding first-type fins 31. The one end portion 4a is left open toward the lower side along the vertical direction. The other end portion 4b is left open toward the back side along the horizontal direction. Accordingly, the passage portions 4 that are positioned in between the first-type fins 31 are formed in a continuous manner and at an angle from the lower side to the back side in the portions between the corresponding one end portions 4a to the other end portions 4b. In the passage portions 4 that are positioned in between the first-type fins 31, the one end portions 4a are left open at the lower end 22d of the base 2, and the other end portions 4b are left open at the posterior end 22b of the base 2. Moreover, since the end edges 3c of the first-type fins 31 range from the corresponding one end portions 3a to the corresponding other end portions 3b at an equal distance from the other surface 21b of the base 2, in the passage portions 4 that are positioned in between the first-type fins 31, the portions from the corresponding one end portions 4a to the corresponding other end portions 4b remain continuous at an equal distance from the other surface 21b of the base 2. Furthermore, since the first-type fins 31 are formed in such a way that the portions between the corresponding one end portions 3a and the corresponding other end portions 3b are linear and at an angle, the passage portions 4 that are positioned in between the first-type fins 31 are formed in such a way that the portions between the corresponding one end portions 4a and the corresponding other end portions 4b are linear and at an angle. The passage portions 4 that are present in between the first-type fins 31 have a uniformly equal interval ranging from the corresponding one end portions 4a to the corresponding other end portions 4b.

In the heat sink 1B, the heat generated by the heating element 104 of the electronic device 101 is transferred to the base 2 and is then transferred from the base 2 to the fins 3. In the heat sink 1B, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1B enables preventing a situation in which the heat builds up in the gap S present above the electronic device 101, and enables achieving enhancement in the cooling efficiency.

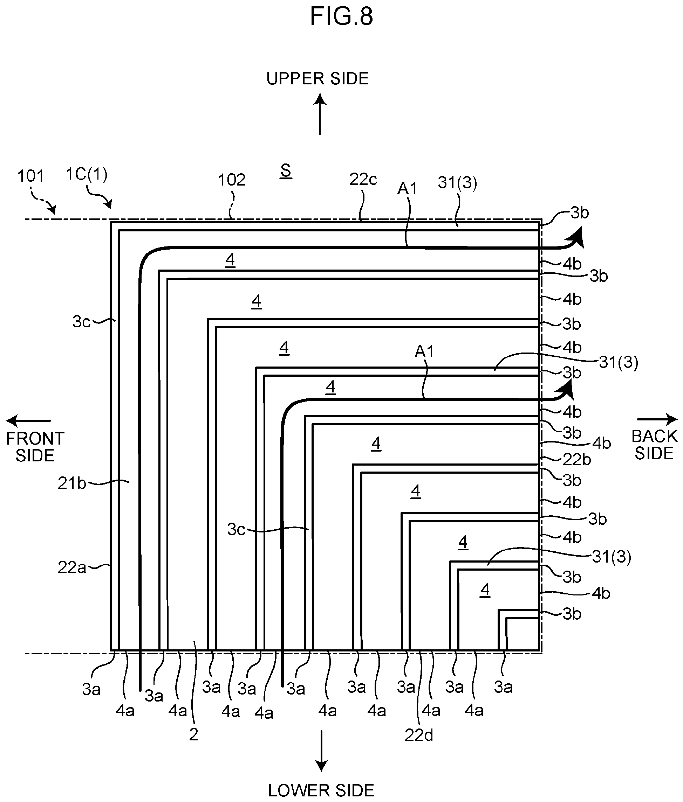

The heat sink 1C illustrated in FIG. 8 includes only the first-type fins 31 that are formed in a bent manner.

The first-type fins 31 are formed in a continuous manner from the one end portions 3a to the other end portions 3b along the other surface 21b of the base 2. The one end portions 3a face toward the lower side. The other end portions 3b face toward the back side. The first-type fins 31 are extended from the lower side to the upper side and are bent to extend in a continuous manner toward the back side. In each first-type fin 31, the one end portion 3a is positioned at the lower end 22d of the base 2, and the other end portion 3b is positioned at the posterior end 22b of the base 2. Moreover, in each first-type fin 31, the end edge 3c that stands upright from the other surface 21b of the base 2 ranges from the one end portion 3a to the other end portion 3b at an equal distance from the other surface 21b of the base 2. That is, when expanded, the first-type fin 31 has the shape of a rectangular long plate and, with one end of the long plate serving as the one end portion 3a and the other end of the long plate serving as the other end portion 3b, is fixed to the other surface 21b of the base 2. Moreover, each first-type fin 31 is formed in such a way that the portion between the one end portion 3a and the other end portion 3b is bent. Along the other surface 21b of the base 2, the first-type fins 31 are arranged side by side with intervals maintained therebetween. Between the neighboring first-type fins 31, the interval along the other surface 21b of the base 2 is uniformly equal ranging from the one end portions 3a to the other end portions 3b.

The passage portions 4 present in between the first-type fins 31 are formed along the other surface 21b of the base 2 and in a continuous manner from the corresponding one end portions 4a to the corresponding other end portions 4b. In each passage portion 4, the one end portion 4a is left open at the positions of the one end portions 3a of the corresponding first-type fins 31, and the other end portion 4b is left open at the positions of the other end portions 3b of the corresponding first-type fins 31. The one end portion 4a is left open toward the lower side along the vertical direction. The other end portion 4b is left open toward the back side along the horizontal direction. Accordingly, the passage portions 4 that are positioned in between the first-type fins 31 are extended from the lower side to the upper side and are bent to extend in a continuous manner toward the back side in the portions between the corresponding one end portions 4a to the corresponding other end portions 4b. In the passage portions 4 that are positioned in between the first-type fins 31, the one end portions 4a are left open at the lower end 22d of the base 2, and the other end portions 4b are left open at the posterior end 22b of the base 2. Moreover, since the end edges 3c of the first-type fins 31 range from the corresponding one end portions 3a to the corresponding other end portions 3b at an equal distance from the other surface 21b of the base 2, in the passage portions 4 that are positioned in between the first-type fins 31, the portions from the corresponding one end portions 4a to the corresponding other end portions 4b remain continuous at an equal distance from the other surface 21b of the base 2. Furthermore, since the first-type fins 31 are formed in such a way that the portions between the corresponding one end portions 3a and the corresponding other end portions 3b are bent, the passage portions 4 that are positioned in between the first-type fins 31 are formed in such a way that the portions between the corresponding one end portions 4a and the corresponding other end portions 4b are bent. The passage portions 4 that are present in between the first-type fins 31 have a uniformly equal interval ranging from the corresponding one end portions 4a to the corresponding other end portions 4b.

In the heat sink 1C, the heat generated by the heating element 104 of the electronic device 101 is transferred to the base 2 and is then transferred from the base 2 to the fins 3. In the heat sink 1C, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1C enables preventing a situation in which the heat builds up in the gap S present above the electronic device 101, and enables achieving enhancement in the cooling efficiency. Moreover, in the heat sink 1C, since the passage portions 4 are formed across the entire base 2, the heat received by the base 2 is transferred to the air present in all passage portions 4, thereby making it possible to reduce the wastage in the movement of the heat toward the back side.

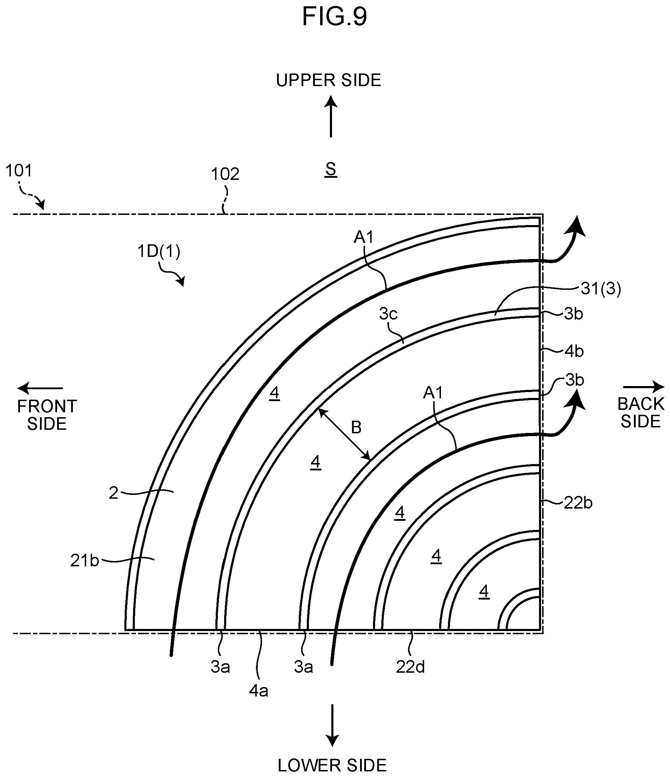

The heat sink 1D illustrated in FIG. 9 includes only the first-type fins 31 that are formed to be curved in an identical manner to the first-type fins 31 in the heat sink 1A.

The first-type fins 31 are formed in a continuous manner from the one end portions 3a to the other end portions 3b along the other surface 21b of the base 2. The one end portions 3a face toward the lower side. The other end portions 3b face toward the back side. The first-type fins 31 are formed in a continuous manner from the lower side to the back side while including the upper side. In each first-type fin 31, the one end portion 3a is positioned at the lower end 22d of the base 2, and the other end portion 3b is positioned at the posterior end 22b of the base 2. Moreover, in each first-type fin 31, the end edge 3c that stands upright from the other surface 21b of the base 2 ranges from the one end portion 3a to the other end portion 3b at an equal distance from the other surface 21b of the base 2. That is, when expanded, the first-type fin 31 has the shape of a rectangular long plate and, with one end of the long plate serving as the one end portion 3a and the other end of the long plate serving as the other end portion 3b, is fixed to the other surface 21b of the base 2. Moreover, each first-type fin 31 is formed in such a way that the portion between the one end portion 3a and the other end portion 3b bulges upward and is curved in the shape of an arc. Along the other surface 21b of the base 2, the first-type fins 31 are arranged side by side with a plurality of intervals B maintained therebetween. Each interval B between the neighboring first-type fins 31 along the other surface 21b of the base 2 is uniformly equal ranging from the one end portions 3a to the other end portions 3b. In the heat sink 1D, the first-type fins 31 are arranged in such a way that the interval B goes on increasing in size toward the outside (the upper side) of the arcs.

The passage portions 4 present in between the first-type fins 31 are formed along the other surface 21b of the base 2 and in a continuous manner from the corresponding one end portions 4a to the corresponding other end portions 4b. In each passage portion 4, the one end portion 4a is left open at the positions of the one end portions 3a of the corresponding first-type fins 31, and the other end portion 4b is left open at the positions of the other end portions 3b of the corresponding first-type fins 31. The one end portion 4a is left open toward the lower side along the vertical direction. The other end portion 4b is left open toward the back side along the horizontal direction. Accordingly, each passage portion 4 that is positioned in between the first-type fins 31 is formed in a continuous manner from the lower side to the back side in the portion between the one end portion 4a to the other end portion 4b. In the passage portions 4 that are positioned in between the first-type fins 31, the one end portions 4a are left open at the lower end 22d of the base 2, and the other end portions 4b are left open at the posterior end 22b of the base 2. Moreover, since the end edges 3c of the first-type fins 31 range from the corresponding one end portions 3a to the corresponding other end portions 3b at an equal distance from the other surface 21b of the base 2, in the passage portions 4 that are positioned in between the first-type fins 31, the portions from the corresponding one end portions 4a to the corresponding other end portions 4b remain continuous at an equal distance from the other surface 21b of the base 2. Furthermore, since the first-type fins 31 are formed in such a way that the portions between the corresponding one end portions 3a and the corresponding other end portions 3b bulge upward and are curved in the shape of an arc, the passage portions 4 that are positioned in between the first-type fins 31 are formed in such a way that the portions between the corresponding one end portions 4a and the corresponding other end portions 4b bulge upward and are curved in the shape of an arc. Thus, the intervals B between the passage portions 4 that are present in between the first-type fins 31 are uniformly equal ranging from the one end portions 4a to the other end portions 4b. Moreover, the passage portions 4 that are positioned in between the first-type fins 31 are arranged in such a way that the interval B goes on increasing in size toward the outside (the upper side) of the arcs.

In the heat sink 1D, the heat generated by the heating element 104 of the electronic device 101 is transferred to the base 2 and is then transferred from the base 2 to the fins 3. In the heat sink 1D, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1D enables preventing a situation in which the heat builds up in the gap S present above the electronic device 101, and enables achieving enhancement in the cooling efficiency.

Moreover, in the heat sink 1D, since the passage portions 4 are arranged in such a way that the interval B goes on increasing in size toward the outside (the upper side) of the arcs, whereas the thermal boundary layers around the fins 3 increases on the upper side on which there is an increase in the temperature of the heat transferred to the base 2, it becomes possible to prevent a situation in which the thermal boundary layers between the neighboring fins 3 interfere with each other, and it becomes possible to facilitate the flow (convection) of the air A1.

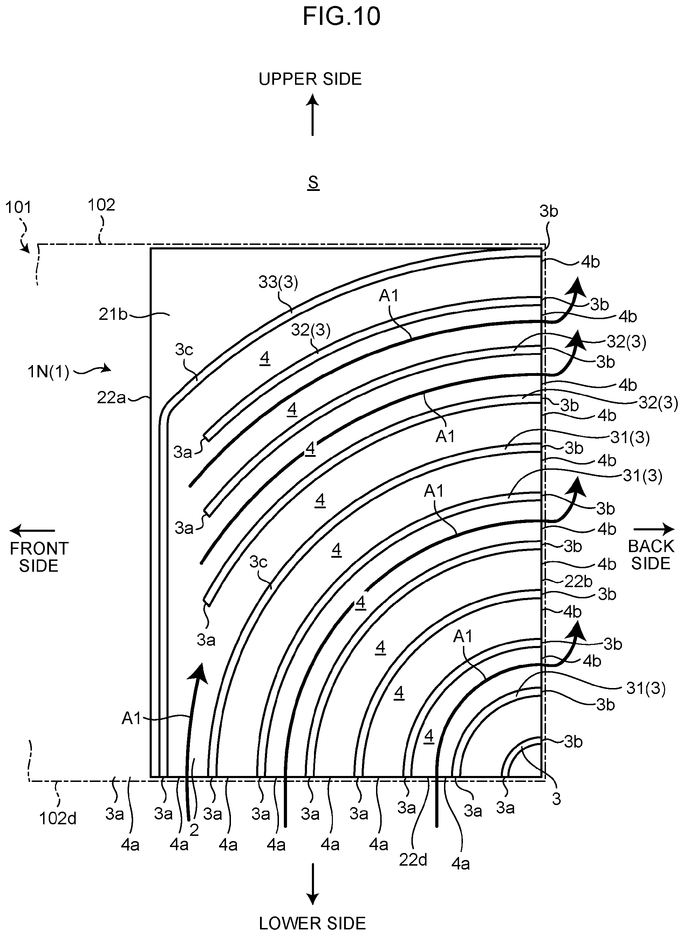

In the heat sink 1N illustrated in FIG. 10, the fins 3 include the first-type fins 31, the second-type fins 32, and a third-type fin 33. Thus, with reference to the heat sink 1A explained earlier, the heat sink 1N illustrated in FIG. 10 additionally includes the third-type fin 33.

The third-type fin 33 is disposed on the outside of the curvature of the second-type fins 32. The third-type fin 33 is formed in the shape of a plate and is disposed in an upright manner from the other surface 21b of the base 2. Moreover, with reference to FIG. 10, the third-type fin 33 is placed to extend toward the right side to move away from the other surface 21b of the base 2. The third-type fin 33 is formed along the other surface 21b of the base 2 and in a continuous manner from the one end portion 3a to the other end portion 3b thereof. The one end portion 3a faces toward the lower side. The other end portion 3b faces toward the back side. Thus, the third-type fin 33 is formed in a continuous manner from the lower side to the back side. In the third-type fin 33, the one end portion 3a is placed at the lower end 22d of the base 2, and the other end portion 3b is placed at the posterior end 22b of the base 2. Moreover, in the third-type fin 33, the end edge 3c that stands upright from the other surface 21b of the base 2 ranges from the one end portion 3a to the other end portion 3b at an equal distance from the other surface 21b of the base 2. That is, when expanded, the third-type fin 33 has the shape of a rectangular long plate and, with one end of the long plate serving as the one end portion 3a and the other end of the long plate serving as the other end portion 3b, is fixed to the other surface 21b of the base 2. Moreover, partway through the portion between the one end portion 3a and the other end portion 3b, the third-type fin 33 is formed in a linear manner along the vertical direction; and, from that point onward, the third-type fin 33 is formed in a curved manner in such a way that the remaining portion till the other end portion 3b bulges upward. In the embodiment, the third-type fin 33 is curved in the shape of an arc so that the portion between a point partway through and the other end portion 3b bulges upward. Herein, only a single third-type fin 33 is used and is disposed to enclose the front side and the upper side of the first-type fins 31 and the second-type fins 32. Along the other surface 21b of the base 2, the third-type fin 33, the first-type fins 31, and the second-type fins 32 are arranged side by side with intervals maintained therebetween. From among the fins 31, 32, and 33, the interval between the neighboring fins 3 along the other surface 21b of the base 2 is equal ranging from the one end portion 3a to the other end portion 3b.

The passage portions 4 present in between the first-type fins 31 are formed along the other surface 21b of the base 2 and in a continuous manner from the corresponding one end portions 4a to the corresponding other end portions 4b. In each passage portion 4, the one end portion 4a is left open at the positions of the one end portions 3a of the corresponding first-type fins 31, and the other end portion 4b is left open at the positions of the other end portions 3b of the corresponding first-type fins 31. The one end portion 4a is left open toward the lower side along the vertical direction. The other end portion 4b is left open toward the back side along the horizontal direction. Accordingly, each passage portion 4 that is positioned in between the first-type fins 31 is formed in a continuous manner from the lower side to the back side in the portion between the one end portion 4a to the other end portion 4b. In the passage portions 4 that are positioned in between the first-type fins 31, the one end portions 4a are left open at the lower end 22d of the base 2, and the other end portions 4b are left open at the posterior end 22b of the base 2. Moreover, since the end edges 3c of the first-type fins 31 range from the corresponding one end portions 3a to the corresponding other end portions 3b at an equal distance from the other surface 21b of the base 2, in the passage portions 4 that are positioned in between the first-type fins 31, the portions from the corresponding one end portions 4a to the corresponding other end portions 4b remain continuous at an equal distance from the other surface 21b of the base 2. Furthermore, since the first-type fins 31 are formed in a curved manner in such a way that the portions between the corresponding one end portions 3a and the corresponding other end portions 3b bulge upward, the passage portions 4 that are positioned in between the first-type fins 31 are formed in a curved manner in such a way that the portions between the corresponding one end portions 4a and the corresponding other end portions 4b bulge upward. Herein, the curvature is formed in the shape of an arc. Thus, The passage portions 4 that are present in between the first-type fins 31 have a uniformly equal interval ranging from the corresponding one end portions 4a to the corresponding other end portions 4b.

Each passage portion 4 corresponding to the second-type fins 32 is formed in a continuous manner from the one end portion 4a to the other end portion 4b along the other surface 21b of the base 2. In each passage portion 4, the one end portion 4a is left open at the positions of the one end portions 3a of the corresponding second-type fins 32, and the other end portion 4b is left open at the positions of the other end portions 3b of the corresponding second-type fins 32. Since the second-type fins 32 and the first-type fins 31 are formed in a curved manner, the one end portions 4a are left open toward the lower side and the front side along the vertical direction. The other end portions 4b are left open toward the back side along the horizontal direction. Accordingly, in each passage portion 4 corresponding to the second-type fins 32, the portion from the one end portion 4a to the other end portion 4b is formed in a continuous manner from the lower side and the front side to the back side. Thus, in each passage portion 4 corresponding to the second-type fins 32, the one end portion 4a is left open at the front end 22a of the base 2, and the other end portion 4b is left open at the posterior end 22b of the base 2. Moreover, since the end edges 3c of the second-type fins 32 range from the corresponding one end portions 3a to the corresponding other end portions 3b at an equal distance from the other surface 21b of the base 2, in the passage portions 4 corresponding to the second-type fins 32, the portions from the corresponding one end portions 4a to the corresponding other end portions 4b remain continuous at an equal distance from the other surface 21b of the base 2. Furthermore, since the second-type fins 32 are formed in a curved manner in such a way that the portions between the corresponding one end portions 3a and the corresponding other end portions 3b bulge upward, the passage portions 4 corresponding to the second-type fins 32 are formed in a curved manner in such a way that the portions between the corresponding one end portions 4a and the corresponding other end portions 4b bulge upward. Herein, the curvature is formed in the shape of an arc.

The passage portion 4 corresponding to the third-type fin 33 is formed in a continuous manner from the one end portion 4a to the other end portion 4b along the other surface 21b of the base 2. In the passage portion 4, the one end portion 4a is left open at the position of the one end portion 3a of the third-type fin 33, and the other end portion 4b is left open at the position of the other end portion 3b of the third-type fin 33. Since the third-type fin 33 is formed in a linear manner along the vertical direction partway through a portion from the one end portion 3a; the third-type fin 33 is disposed to cover, in the abovementioned portion, the front side of the one end portions 4a of the passage portions 4 formed by all second-type fins 32. Moreover, in a portion partway through to the other end portion 3b, since the third-type fin 33 is formed in the shape of an arc; within the abovementioned portion, the third-type fin 33 is disposed in the shape of an arc along the outside of the second-type fins 32. That is, when all second-type fins 32 are disposed in between the third-type fin 33 and the outermost first-type fin 31, in order to ensure that the passage portions 4 corresponding to all second-type fins 32 are arranged on the inside of the passage portion 4 corresponding to the third-type fin 33; in the passage portion 4 corresponding to the third-type fin 33, the one end portion 4a is left open toward the lower side along the vertical direction and the other end portion 4b is left open toward the back side along the horizontal direction. Accordingly, the passage portion 4 corresponding to the third-type fin 33 is formed in a continuous manner from the lower side to the back side in the portion between the one end portion 4a to the other end portion 4b. In the passage portion 4 corresponding to the third-type fin 33, the one end portion 4a is left open at the lower end 22d of the base 2, and the other end portion 4b is left open at the posterior end 22b of the base 2. Moreover, since the end edge 3c of each fin from among the fins 31, 32, and 33 ranges from the corresponding one end portion 3a to the corresponding other end portion 3b at an equal distance from the other surface 21b of the base 2, the portion from the one end portion 4a to the other end portion 4b remains continuous at an equal distance from the other surface 21b of the base 2. Furthermore, since the third-type fin 33 is formed in a linear manner along the vertical direction partway through the portion from the one end portion 3a, the passage portion 4 corresponding to the third-type fin 33 is formed along the vertical direction in the abovementioned portion. Moreover, since the third-type fin 33 is formed in a curved manner in such a way that the portion partway through to the other end portion 3b bulges upward, the passage portion 4 corresponding to the third-type fin 33 is formed in a curved manner in such a way that the portion between the one end portion 4a and the other end portion 4b bulges upward. Herein, the curvature is formed in the shape of an arc.

In the heat sink 1N, the heat generated by the heating element 104 of the electronic device 101 is transferred to the base 2 and is then transferred from the base 2 to the fins 3. As illustrated in FIG. 10, in the heat sink 1N, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1N enables preventing a situation in which the heat builds up in the gap S present above the electronic device 101, and enables achieving enhancement in the cooling efficiency.

Moreover, in the heat sink 1N, when all second-type fins 32 are disposed in between the third-type fin 33 and the outermost first-type fin 31, in order to ensure that the passage portions 4 corresponding to all second-type fins 32 are arranged on the inside of the passage portion 4 corresponding to the third-type fin 33; in the passage portion 4 corresponding to the third-type fin 33, the one end portion 4a is left open toward the lower side and the other end portion 4b is left open toward the back side. For that reason, in the heat sink 1N, it can be ensured that the air A1 in the passage portions 4 corresponding to all second-type fins 32 flows from the lower side toward the back side.

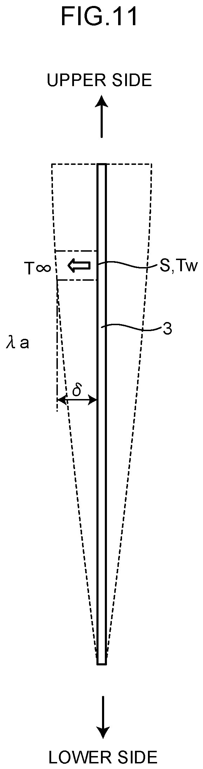

Explained below with reference to FIG. 11 is a thermal boundary layer. In FIG. 11 is illustrated the fin 3 when viewed from the end edge 3c toward the base 2. When the fin 3 gets heated, the heat gets transferred to the air to which the fin 3 is exposed, and there occurs a rise in the temperature of that air. For that reason, the heated air to which the fin 3 is exposed forms a thermal boundary layer around the fin 3 as illustrated by dashed lines. Then, the heated air becomes lighter and buoyant, and rises in convection. In the heat sink 1 according to the embodiment, since the fin 3 is disposed ranging from the lower side to the upper side, the heated air surrounding the fin 3 rises along the fin 3. Since the heated air moves upward and increases in volume more toward the upper side, the thermal boundary layer increases in thickness as illustrated by an arrow.

At that time, the heat flow [W] based on the convection of the air is expressed using the coefficient of convection heat transfer [W/m$^2$K] in Equation (1) given below.

Heat flow [W]=(convective heat transfer area [m$^2$])$\times$(coefficient of convection heat transfer [W/m$^2$K])$\times$((surface temperature)-(fluid temperature [K]))     (Equation 1)

Moreover, regarding the thermal boundary layer illustrated in FIG. 11, a thickness $\delta$ is expressed according to Equation 2 given below.

Heat flow [W]=(partial surface area [m$^2$])$\times$((heat transfer coefficient $\lambda$a [W/m$^2$K]))/(thickness $\delta$ [m] of thermal boundary layer))$\times$((surface temperature Tw)-(fluid temperature T$\propto$[K])) (Equation 2)

Based on such relationships, in order to reduce the effect of the thermal boundary layer and to facilitate the flow (the convective heat transfer) of the air A1, it is important to prevent the interference among the thermal boundary layers; so that, when the flow of the air A1 is facilitated and the heat transfer efficiency is enhanced, the thermal boundary layers become thinner, thereby further facilitating the flow of the air A1 and enhancing the cooling efficiency.

From that perspective, as in the case of the heat sink 1D, when the passage portions 4 are positioned in such a way that the interval B goes on increasing toward the outside (the upper side) of the arcs, the interference between the thermal boundary layers of the neighboring fins 3 can be prevented and the cooling efficiency can be further enhanced.

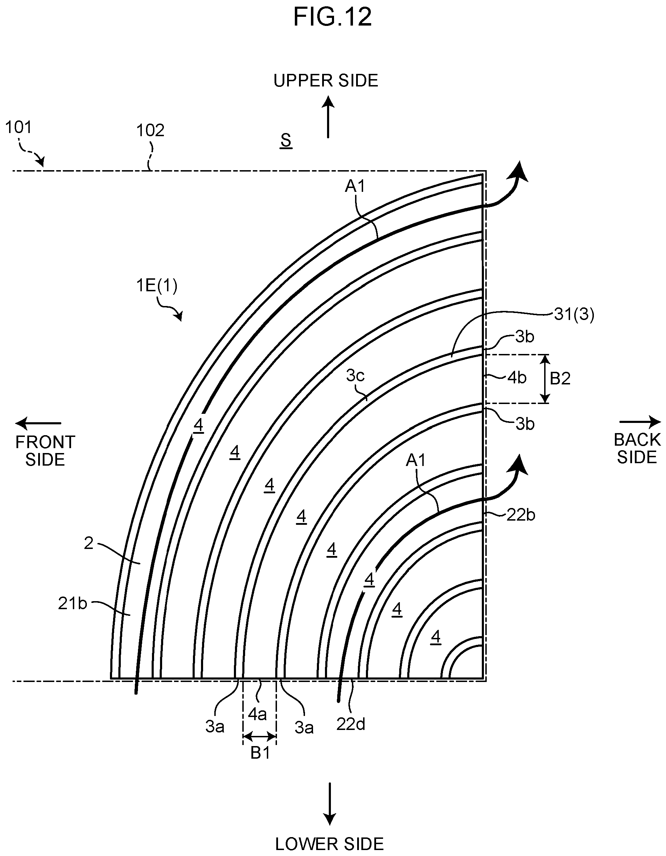

The heat sink 1E illustrated in FIG. 12 includes only the first-type fins 31 that are formed to be curved in an identical manner to the first-type fins 31 in the heat sink 1A.

The first-type fins 31 are formed in a continuous manner from the one end portions 3a to the other end portions 3b along the other surface 21b of the base 2. The one end portions 3a face toward the lower side. The other end portions 3b face toward the back side. The first-type fins 31 are formed in a continuous manner from the lower side to the back side while including the upper side. In each first-type fin 31, the one end portion 3a is positioned at the lower end 22d of the base 2, and the other end portion 3b is positioned at the posterior end 22b of the base 2. Moreover, in each first-type fin 31, the end edge 3c that stands upright from the other surface 21b of the base 2 ranges from the one end portion 3a to the other end portion 3b at an equal distance from the other surface 21b of the base 2. That is, when expanded, the first-type fin 31 has the shape of a rectangular long plate and, with one end of the long plate serving as the one end portion 3a and the other end of the long plate serving as the other end portion 3b, is fixed to the other surface 21b of the base 2. Moreover, each first-type fin 31 is formed in a curved manner in such a way that the portion between the one end portion 3a and the other end portion 3b bulges upward. Along the other surface 21b of the base 2, the first-type fins 31 are arranged side by side with the plurality of intervals B maintained therebetween. In the heat sink 1E, regarding the relationship between the neighboring first-type fins 31, those first-type fins 31 are arranged to undergo such gradual changes that an interval B2 between the other end portions 3b is greater than an interval B1 between the one end portions 3a.

The passage portions 4 present in between the first-type fins 31 are formed along the other surface 21b of the base 2 and in a continuous manner from the corresponding one end portions 4a to the corresponding other end portions 4b. In each passage portion 4, the one end portion 4a is left open at the positions of the one end portions 3a of the corresponding first-type fins 31, and the other end portion 4b is left open at the positions of the other end portions 3b of the corresponding first-type fins 31. The one end portion 4a is left open toward the lower side along the vertical direction. The other end portion 4b is left open toward the back side along the horizontal direction. Accordingly, each passage portion 4 that is positioned in between the first-type fins 31 is formed in a continuous manner from the lower side to the back side in the portion between the one end portion 4a to the other end portion 4b. In the passage portions 4 that are positioned in between the first-type fins 31, the one end portions 4a are left open at the lower end 22d of the base 2, and the other end portions 4b are left open at the posterior end 22b of the base 2. Moreover, since the end edges 3c of the first-type fins 31 range from the corresponding one end portions 3a to the corresponding other end portions 3b at an equal distance from the other surface 21b of the base 2, in the passage portions 4 that are positioned in between the first-type fins 31, the portions from the corresponding one end portions 4a to the corresponding other end portions 4b remain continuous at an equal distance from the other surface 21b of the base 2. Furthermore, since the first-type fins 31 are formed in a curved manner in such a way that the portions between the corresponding one end portions 3a and the corresponding other end portions 3b bulge upward, the passage portions 4 that are positioned in between the first-type fins 31 are formed in a curved manner in such a way that the portions between the corresponding one end portions 4a and the corresponding other end portions 4b bulge upward. Herein, the passage portions 4 that are present in between the first-type fins 31 are formed to gradually increase in size from the interval B1 to the interval B2 in the portion from the one end portion 4a to the other end portion 4b.

In the heat sink 1E, the heat generated by the heating element 104 of the electronic device 101 is transferred to the base 2 and is then transferred from the base 2 to the fins 3. In the heat sink 1E, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1E enables preventing a situation in which the heat builds up in the gap S present above the electronic device 101, and enables achieving enhancement in the cooling efficiency.

Moreover, in the heat sink 1E, the passage portions 4 are arranged with varying intervals in such a way that the interval B2 at the corresponding other end portions 4b becomes greater in size than the interval B1 at the corresponding one end portions 4a. Hence, whereas the thermal boundary layers around the fins 3 increases on the upper side on which there is an increase in the temperature of the heat transferred to the base 2, it becomes possible to prevent a situation in which the thermal boundary layers between the neighboring fins 3 interfere with each other, and it becomes possible to facilitate the flow (convection) of the air A1. That enables achieving further enhancement in the cooling efficiency.

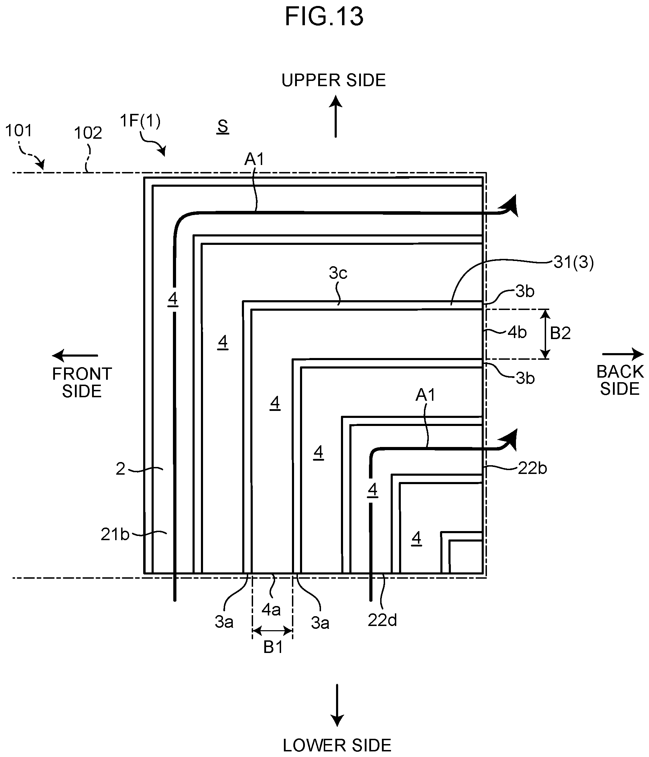

The heat sink 1F illustrated in FIG. 13 includes only the first-type fins 31 that are formed to be bent in an identical manner to the first-type fins 31 in the heat sink 1C.

The first-type fins 31 are formed in a continuous manner from the one end portions 3a to the other end portions 3b along the other surface 21b of the base 2. The one end portions 3a face toward the lower side. The other end portions 3b face toward the back side. The first-type fins 31 are extended from the lower side to the upper side and are bent to extend in a continuous manner toward the back side. In each first-type fin 31, the one end portion 3a is positioned at the lower end 22d of the base 2, and the other end portion 3b is positioned at the posterior end 22b of the base 2. Moreover, in each first-type fin 31, the end edge 3c that stands upright from the other surface 21b of the base 2 ranges from the one end portion 3a to the other end portion 3b at an equal distance from the other surface 21b of the base 2. That is, when expanded, the first-type fin 31 has the shape of a rectangular long plate and, with one end of the long plate serving as the one end portion 3a and the other end of the long plate serving as the other end portion 3b, is fixed to the other surface 21b of the base 2. Moreover, each first-type fin 31 is formed in such a way that the portion between the one end portion 3a and the other end portion 3b is bent. Along the other surface 21b of the base 2, the first-type fins 31 are arranged side by side with intervals maintained therebetween. In the heat sink 1F, regarding the relationship between the neighboring first-type fins 31, the first-type fins 31 are arranged to undergo such changes that the interval B2 between the other end portions 3b is greater than the interval B1 between the one end portions 3a. The interval B1 between the one end portions 3a is uniform till the bent portion and, from the bent portion, the interval changes to the interval B2 between the other end portion 3b.

The passage portions 4 present in between the first-type fins 31 are formed along the other surface 21b of the base 2 and in a continuous manner from the corresponding one end portions 4a to the corresponding other end portions 4b. In each passage portion 4, the one end portion 4a is left open at the positions of the one end portions 3a of the corresponding first-type fins 31, and the other end portion 4b is left open at the positions of the other end portions 3b of the corresponding first-type fins 31. The one end portion 4a is left open toward the lower side along the vertical direction. The other end portion 4b is left open toward the back side along the horizontal direction. Accordingly, the passage portions 4 that are positioned in between the first-type fins 31 are extended from the lower side to the upper side and are bent to extend in a continuous manner toward the back side in the portions between the corresponding one end portions 4a to the corresponding other end portions 4b. In the passage portions 4 that are positioned in between the first-type fins 31, the one end portions 4a are left open at the lower end 22d of the base 2, and the other end portions 4b are left open at the posterior end 22b of the base 2. Moreover, since the end edges 3c of the first-type fins 31 range from the corresponding one end portions 3a to the corresponding other end portions 3b at an equal distance from the other surface 21b of the base 2, in the passage portions 4 that are positioned in between the first-type fins 31, the portions from the corresponding one end portions 4a to the corresponding other end portions 4b remain continuous at an equal distance from the other surface 21b of the base 2. Furthermore, since the first-type fins 31 are formed in such a way that the portions between the corresponding one end portions 3a and the corresponding other end portions 3b are bent, the passage portions 4 that are positioned in between the first-type fins 31 are formed in such a way that the portions between the corresponding one end portions 4a and the corresponding other end portions 4b are bent. The passage portions 4 that are present in between the first-type fins 31 are arranged in such a way that the interval B2 at the corresponding other end portions 4b becomes greater than the interval B1 at the corresponding one end portions 4a.

In the heat sink 1F, the heat generated by the heating element 104 of the electronic device 101 is transferred to the base 2 and is then transferred from the base 2 to the fins 3. In the heat sink 1F, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1F enables preventing a situation in which the heat builds up in the gap S present above the electronic device 101, and enables achieving enhancement in the cooling efficiency.

Moreover, in the heat sink 1F, the passage portions 4 are arranged with varying intervals in such a way that the interval B2 at the corresponding other end portions 4b becomes greater than the interval B1 at the corresponding one end portions 4a. Hence, whereas the thermal boundary layers around the fins 3 increases on the upper side on which there is an increase in the temperature of the heat transferred to the base 2, it becomes possible to prevent a situation in which the thermal boundary layers between the neighboring fins 3 interfere with each other, and it becomes possible to facilitate the flow (convection) of the air A1. That enables achieving further enhancement in the cooling efficiency.

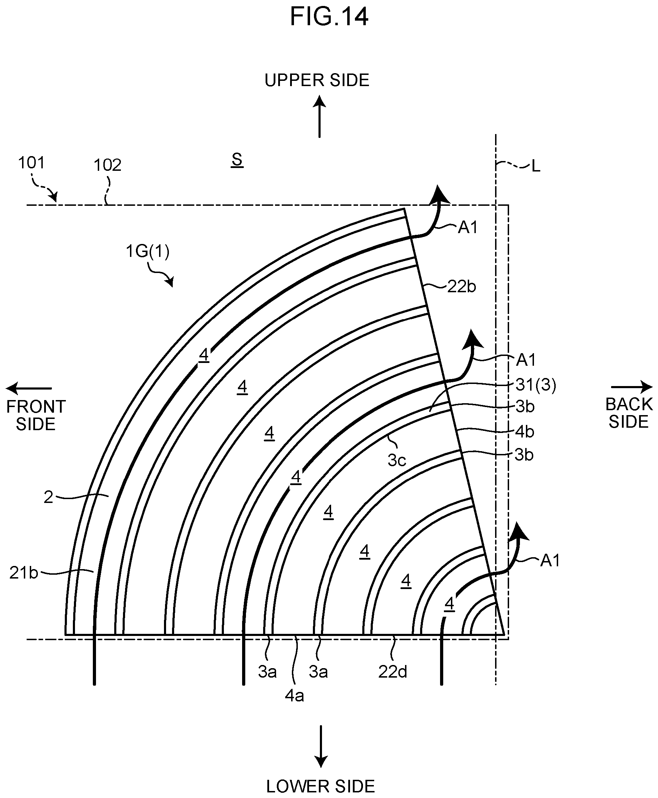

The heat sink 1G illustrated in FIG. 14 includes only the first-type fins 31 that are formed to be curved in an identical manner to the first-type fins 31 in the heat sink 1A.

The first-type fins 31 are formed in a continuous manner from the one end portions 3a to the other end portions 3b along the other surface 21b of the base 2. The one end portions 3a face toward the lower side. The other end portions 3b face toward the back side. The first-type fins 31 are formed in a continuous manner from the lower side to the back side. In each first-type fin 31, the one end portion 3a is positioned at the lower end 22d of the base 2, and the other end portion 3b is positioned at the posterior end 22b of the base 2. Moreover, in each first-type fin 31, the end edge 3c that stands upright from the other surface 21b of the base 2 ranges from the one end portion 3a to the other end portion 3b at an equal distance from the other surface 21b of the base 2. That is, when expanded, the first-type fin 31 has the shape of a rectangular long plate and, with one end of the long plate serving as the one end portion 3a and the other end of the long plate serving as the other end portion 3b, is fixed to the other surface 21b of the base 2. Moreover, each first-type fin 31 is formed in a curved manner in such a way that the portion between the one end portion 3a and the other end portion 3b bulges upward. Along the other surface 21b of the base 2, the first-type fins 31 are arranged side by side with the plurality of intervals B maintained therebetween. The interval between the neighboring first-type fins 31 along the other surface 21b of the base 2 is uniformly equal ranging from the one end portions 3a to the other end portions 3b.

The passage portions 4 present in between the first-type fins 31 are formed along the other surface 21b of the base 2 and in a continuous manner from the corresponding one end portions 4a to the corresponding other end portions 4b. In each passage portion 4, the one end portion 4a is left open at the positions of the one end portions 3a of the corresponding first-type fins 31, and the other end portion 4b is left open at the positions of the other end portions 3b of the corresponding first-type fins 31. The one end portion 4a is left open toward the lower side along the vertical direction. The other end portion 4b is left open toward the back side along the horizontal direction. Accordingly, each passage portion 4 that is positioned in between the first-type fins 31 is formed in a continuous manner from the lower side to the back side in the portion between the one end portion 4a to the other end portion 4b. In the passage portions 4 that are positioned in between the first-type fins 31, the one end portions 4a are left open at the lower end 22d of the base 2, and the other end portions 4b are left open at the posterior end 22b of the base 2. Moreover, since the end edges 3c of the first-type fins 31 range from the corresponding one end portions 3a to the corresponding other end portions 3b at an equal distance from the other surface 21b of the base 2, in the passage portions 4 that are positioned in between the first-type fins 31, the portions from the corresponding one end portions 4a to the corresponding other end portions 4b remain continuous at an equal distance from the other surface 21b of the base 2. Furthermore, since the first-type fins 31 are formed in a curved manner in such a way that the portions between the corresponding one end portions 3a and the corresponding other end portions 3b bulge upward, the passage portions 4 that are positioned in between the first-type fins 31 are formed in a curved manner in such a way that the portions between the corresponding one end portions 4a and the corresponding other end portions 4b bulge upward. Thus, The passage portions 4 that are present in between the first-type fins 31 have a uniformly equal interval ranging from the corresponding one end portions 4a to the corresponding other end portions 4b.

In the heat sink 1G, within the range of the other surface 21b of the base 2, the other end portions 3b of the first-type fins 31 that constitute the other end portions 4b of the passage portions 4 have different positions with respect to a vertical line L. More particularly, in the heat sink 1G, the posterior end 22b of the base 2 is formed to be inclined toward the acute angle side with respect to the vertical line L. The other end portion 3b of each first-type fin 31 is disposed to match with the posterior end 22b of the base 2. For that reason, within the range of the other surface 21b of the base 2, the other end portions 3b of the first-type fins 31 are arranged to become gradually shorter from the lower side to the upper side with respect to the vertical line L, with the lowermost first-type fin 31 serving as the reference.

In the heat sink 1G, the heat generated by the heating element 104 of the electronic device 101 is transferred to the base 2 and is then transferred from the base 2 to the fins 3. In the heat sink 1G, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1G enables preventing a situation in which the heat builds up in the gap S present above the electronic device 101, and enables achieving enhancement in the cooling efficiency.

Moreover, in the heat sink 1G, within the range of the other surface 21b of the base 2, the other end portions 3b of the first-type fins 31 are arranged to become gradually shorter from the lower side to the upper side with respect to the vertical line L, with the lowermost first-type fin 31 serving as the reference. Hence, the heat liberated from the passage portions 4 positioned in between the first-type fins 31 moves upward without being obstructed by the first-type fins 31 on the upper side. As a result, in the heat sink 1G, the heat can be released over a wider range, thereby enabling achieving further enhancement in the cooling efficiency.

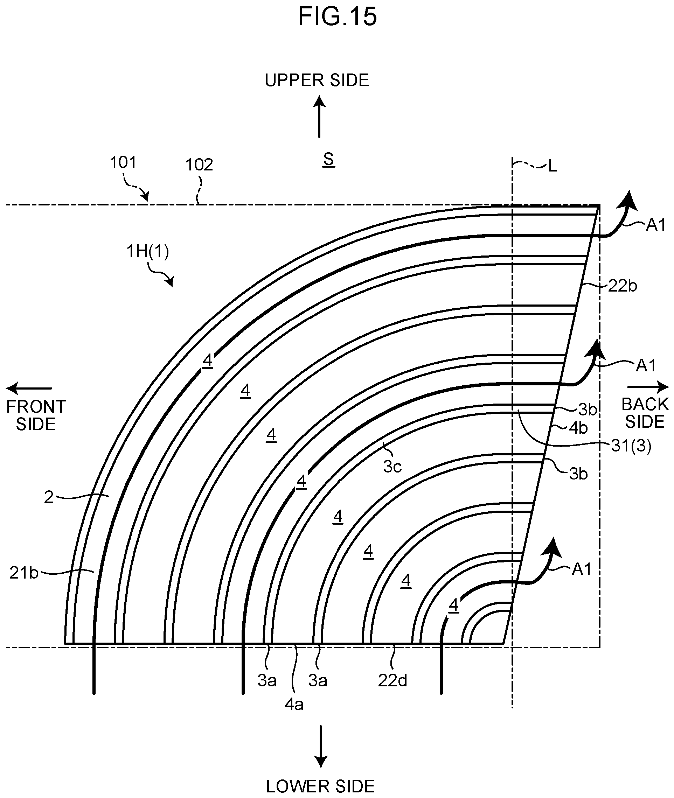

The heat sink 1H illustrated in FIG. 15 has the identical basic configuration to the basic configuration of the heat sink 1G. Thus, within the range of the other surface 21b of the base 2, the other end portions 3b of the first-type fins 31 that constitute the other end portions 4b of the passage portions 4 have different positions with respect to the vertical line L. However, in the heat sink 1H, the posterior end 22b of the base 2 is formed to be inclined toward the obtuse angle side with respect to the vertical line L. In each first-type fin 31, the other end portion 3b is arranged to match with the posterior end 22b

of the base 2. For that reason, within the range of the other surface 21b of the base 2, the other end portions 3b of the first-type fins 31 are arranged to become gradually longer from the lower side to the upper side with respect to the vertical line L, with the lowermost first-type fin 31 serving as the reference.

In the heat sink 1H, the heat generated by the heating element 104 of the electronic device 101 is transferred to the base 2 and is then transferred from the base 2 to the fins 3. In the heat sink 1H, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1H enables preventing a situation in which the heat builds up in the gap S present above the electronic device 101, and enables achieving enhancement in the cooling efficiency.

Moreover, in the heat sink 1H, within the range of the other surface 21b of the base 2, the other end portions 3b of the first-type fins 31 are arranged to become gradually longer from the lower side to the upper side with respect to the vertical line L, with the lowermost first-type fin 31 serving as the reference. Hence, regarding the heat liberated from the passage portions 4 positioned in between the first-type fins 31, the upward movement is held down by the first-type fins 31 on the upper side, and the heat can be released more toward the back side with respect to the vertical line L. As a result, the heat sink 1H enables holding down the heat release into the gap S present above the main body unit 102 of the electronic device 101, and enables achieving further enhancement in the cooling efficiency.

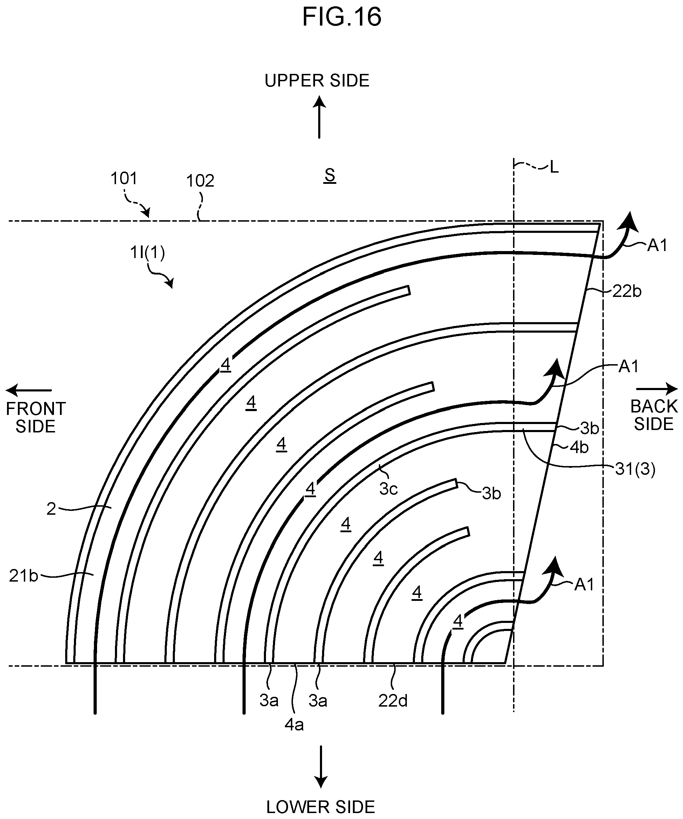

The heat sink 1I illustrated in FIG. 16 has the identical basic configuration to the basic configuration of the heat sink 1G. Thus, within the range of the other surface 21b of the base 2, the other end portions 3b of the first-type fins 31 that constitute the other end portions 4b of the passage portions 4 have different positions with respect to the vertical line L. However, in the heat sink 1I, the posterior end 22b of the base 2 is formed to be inclined toward the obtuse angle side with respect to the vertical line L. Moreover, within the range of the other surface 21b of the base 2, the other end portions 3b of the first-type fins 31 are arranged in an uneven manner with respect to the vertical line L.

In the heat sink 1I, the heat generated by the heating element 104 of the electronic device 101 is transferred to the base 2 and is then transferred from the base 2 to the fins 3. In the heat sink 1I, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1I enables preventing a situation in which the heat builds up in the gap S present above the electronic device 101, and enables achieving enhancement in the cooling efficiency.

Moreover, in the heat sink 1I, within the range of the other surface 21b of the base 2, the other end portions 3b of the first-type fins 31 are arranged in an uneven manner with respect to the vertical line L. Hence, regarding the heat liberated from the passage portions 4 positioned in between the first-type fins 31, the upward movement occurs without being obstructed by the first-type fins 31 on the upper side as well as the upward movement is held down by the first-type fins 31 on the upper side. As a result, the heat sink 1I produces the effect of enabling heat release in a wider range as well as produces the effect of enabling holding down the heat release into the gap S present above the main body unit 102 of the electronic device 101, and thus enables achieving further enhancement in the cooling efficiency. Moreover, within the range of the other surface 21b of the base 2, when the length of the first-type fins 31 is shortened as explained above, the flow passage portions between the long first-type fins 31 expand from the other end portions 3b of the short first-type fins 31 toward the exit side represented by the other end portions 4b of the passage portions 4, and the interference interval of the thermal boundary layers can be optimized. On the other hand, the interval between the first-type fins 31 at the entry side represented by the one end portions 4a of the passage portions 4 can be narrowed to secure the fin count, thereby enabling further enhancement in the cooling efficiency.

The heat sink 1 according to the first embodiment is characterized by including: the base 2 having the plate-like one surface 21a attached along the outer surface of the right plate 102f representing an upright wall portion of the main body unit 102 of the electronic device 101; a plurality of fins 3 arranged side by side along the plate-like other surface 21b of the base 2; and the passage portions 4 that are formed in between the fins 3 and in a continuous manner along the other surface 21b of the base 2. In the state in which the base 2 is attached to the right plate 102f, the fins 3 are formed in such a way that the one end portions 4a of the passage portions 4 are left open toward the lower side along the vertical direction and that the other end portions 4b of all passage portions 4 are positioned on the upper side with respect to the one end portions 4a and are left open along the horizontal direction.

In the heat sink 1, the air A1 that is present in the passage portions 4 formed in between the fins 3 moves upward and flows from the one end portions 4a, which are positioned on the lower side, toward the other end portions 4b, which are positioned on the upper side; and is liberated to the back side along the horizontal direction toward which the other end portions 4b are oriented and which is more on the back side than the back plate 102b of the main body unit 102 of the electronic device 101. As a result, the heat sink 1 enables preventing a situation in which the heat builds up in the gap S present above the electronic device 101, and enables achieving enhancement in the cooling efficiency.

Moreover, in the heat sink 1 according to the first embodiment, the neighboring fins 3 are arranged with varying intervals in such a way that the one end portions 4a of the passage portions 4 become greater in size than the other end portions 4b.

In the heat sink 1, a situation in which the thermal boundary layers between the neighboring fins 3 interfere with each other can be prevented and the flow (convection) of the air A1 can be facilitated, thereby enabling achieving further enhancement in the cooling efficiency.

Moreover, in the heat sink 1 according to the embodiment, the fins 3 are formed in a curved manner in such a way that the passage portions 4 bulge upward.

In the heat sink 1, as a result of forming the passage portions 4 in a curved manner, within the range of the other surface 21b of the base 2, the length of the passage portions 4 can be extended and the amount of heat transferred from the base 2 to the fins 3 can be increased as compared to the passage portions 4 having the linear shape, and hence further enhancement in the cooling efficiency can be achieved.

In the heat sink 1 according to the embodiment, within the range of the other surface 21b of the base 2, the other end portions 3b of the fins 3 constituting the other end portions 4b of the passage portions 4 have different positions with respect to the vertical line L.

In the heat sink 1, the heat liberated from the passage portions 4 positioned in between the fins 3 moves upward without being obstructed by the fins 3 on the upper side, as well as the upward movement of the heat is held down by the fins 3 on the upper side. As a result, the heat sink 1 produces the effect of enabling heat release in a wider range as well as produces the effect of enabling holding down the heat release into the gap S present above the main body unit 102 of the electronic device 101, and thus enables achieving further enhancement in the cooling efficiency.

In the electronic device 101 according to the first embodiment, the heat sink 1 explained above is used.

Thus, the electronic device 101 enables preventing a situation in which the heat builds up in the gap S present above, and enables achieving enhancement in the cooling efficiency.

The first embodiment described above includes the following inventions.

[Invention 1]

A heat sink including:

a base that has a plate-like one surface attached to outer surface of an upright wall portion of an electronic device;
a plurality of fins arranged side by side along a plate-like other surface of the base; and
passage portions that are formed in between the fins and in a continuous manner along the other surface of the base, wherein
in a state in which the base is attached to the upright wall portion, the fins are formed in such a way that one end portions of the passage portions are left open toward lower side along vertical direction and that other end portions of all of the passage portions are positioned on upper side with respect to the one end portions and are left open along horizontal direction.

[Invention 2]

The heat sink according to invention 1, wherein the neighboring fins are arranged with varying intervals in such a way that the one end portions of the passage portions become greater in size than the other end portions.

[Invention 3]

The heat sink according to invention 1 or 2, wherein the fins are formed in a curved manner in such a way that the passage portions bulge upward.

[Invention 4]

The heat sink according to any one of inventions 1 to 3, wherein, within range of other surface of the base, end portions of the fins constituting the other end portions of the passage portions have different positions with respect to a vertical line.

[Invention 5]

An electronic device including:

a device main body in which

a heating element is disposed on inner surface of a predetermined upright wall portion, and
a plate member is placed above upper lateral wall portion to which upper end of the predetermined upright wall portion is connected; and

the heat sink according to any one of inventions 1 to 4.

[Second embodiment of heat sink]

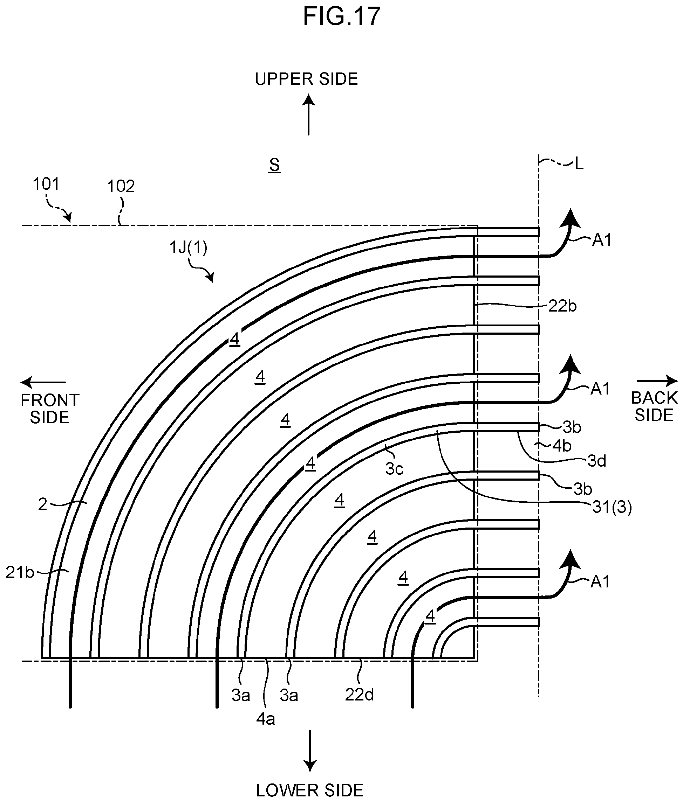

Regarding the heat sink 1 according to a second embodiment, the detailed explanation is given below with reference to FIGS. 17 to 20. In each drawing, it is illustrated that the heat sink 1 is attached to the right plate 102f representing an upright wall portion.

Herein, heat sinks 1J, 1K, 1L, and 1M according to the second embodiment differ from the heat sink 1 according to the first embodiment mainly in terms of the shape of the fins 3. Thus, equivalent constituent elements are referred to by the same reference numerals, and their explanation is not given in a repeated manner.

The heat sinks 1J, 1K, 1K, and 1M illustrated from FIGS. 17 to 20 include only the first-type fins 31 that are formed in a curved manner in an identical manner to the first-type fins 31 in the heat sink 1A.

The first-type fins 31 are formed in a continuous manner from the one end portions 3a to the other end portions 3b along the other surface 21b of the base 2. The one end portions 3a face toward the lower side. The other end portions 3b face toward the back side. The first-type fins 31 are formed in a continuous manner from the lower side to the back side while including the upper side. In each first-type fin 31, the one end portion 3a is positioned at the lower end 22d of the base 2, and the other end portion 3b is positioned at the posterior end 22b of the base 2. Moreover, in each first-type fin 31, the end edge 3c that stands upright from the other surface 21b of the base 2 ranges from the one end portion 3a to the other end portion 3b at an equal distance from the other surface 21b of the base 2. That is, when expanded, the first-type fin 31 has the shape of a rectangular long plate and, with one end of the long plate serving as the one end portion 3a and the other end of the long plate serving as the other end portion 3b, is fixed to the other surface 21b of the base 2. Moreover, each first-type fin 31 is formed in a curved manner in such a way that the portion between the one end portion 3a and the other end portion 3b bulges upward. Along the other surface 21b of the base 2, the first-type fins 31 are arranged side by side with the plurality of intervals B maintained therebetween. The interval between the neighboring first-type fins 31 along the other surface 21b of the base 2 is uniformly equal ranging from the one end portions 3a to the other end portions 3b.

The passage portions 4 present in between the first-type fins 31 are formed along the other surface 21b of the base 2 and in a continuous manner from the corresponding one end portions 4a to the corresponding other end portions 4b. In each passage portion 4, the one end portion 4a is left open at the positions of the one end portions 3a of the corresponding first-type fins 31, and the other end portion 4b is left open at the positions of the other end portions 3b of the corresponding first-type fins 31. The one end portion 4a is left open toward the lower side along the vertical direction. The other end portion 4b is left open toward the back side along the horizontal direction. Accordingly, each passage portion 4 that is positioned in between the first-type fins 31 is formed in a continuous manner from the lower side to the back side in the portion between the one end portion 4a to the other end portion 4b. In the passage portions 4 that are positioned in between the first-type fins 31, the one end portions 4a are left open at the lower end 22d of the base 2, and the other end portions 4b are left open at the posterior end 22b of the base 2. Moreover, since the end edges 3c of the first-type fins 31 range from the corresponding one end portions 3a to the corresponding other end portions 3b at an equal distance from the other surface 21b of the base 2, in the passage portions 4 that are positioned in between the first-type fins 31, the portions from the corresponding one end portions 4a to the corresponding other end portions 4b remain continuous at an equal distance from the other surface 21b of the base 2. Furthermore, since the first-type fins 31 are formed in a curved manner in such a way that the portions between the corresponding one end portions 3a and the corresponding other end portions 3b bulge upward, the passage portions 4 that are positioned in between the first-type fins 31 are formed in a curved manner in such a way that the portions between the corresponding one end portions 4a and the corresponding other end portions 4b bulge upward. Thus, The passage portions 4 that are present in between the first-type fins 31 have a uniformly equal interval ranging from the corresponding one end portions 4a to the corresponding other end portions 4b.

In the heat sink 1J illustrated in FIG. 17, each first-type fin 31 includes an extended portion 3d because of which the other end portion 3b extends in the horizontal direction from the posterior end 22b of the base 2 to the outside of the range of the other surface 21b of the base 2 (i.e., toward the back side). Thus, the extended portion 3d is placed to extend in the horizontal direction. In the heat sink 1J, the first-type fins 31 are arranged in such a way that, because of the extended portions 3d, the corresponding other end portions 3b, which have extended to the outside of the range of the other surface 21b of the base 2, remain aligned with respect to the vertical line L. For that reason, in the heat sink 1J, the first-type fins 31 constituting the other end portions 4b of the passage portions 4 are formed to extend along the horizontal direction more to the back side than the posterior end 22b of the base 2 and outside the range of the other surface 21b of the base 2.

In the heat sink 1J, the heat generated by the heating element 104 of the electronic device 101 is transferred to the base 2 and is then transferred from the base 2 to the fins 3. In the heat sink 1J, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1J enables preventing a situation in which the heat builds up in the gap S present above the electronic device 101, and enables achieving enhancement in the cooling efficiency.

Moreover, the other end portions 3b of the first-type fins 31, which constitute the other end portions 4b of the passage portions 4 on the outside of the range of the other surface 21b of the base 2, are formed to extend along the horizontal direction. Hence, the heat liberated from the passage portions 4 positioned in between the first-type fins 31 is guided to the outside of the range of the other surface 21b of the base 2. Furthermore, in the heat sink 1J, regarding the other end portions 3b of the first-type fins 31 protruding more on the back side than the posterior end 22b of the base 2, the end surfaces become exposed from the portion joined at the other surface 21b of the base 2. Hence, the heat gets transferred from the heating element 104 and can be released at a position separated from the base 2 that is at a high temperature. Moreover, in the heat sink 1J, the heat can be released also from the side of the end surface that is separated from the base 2 and that is in the exposed state. As a result, in the heat sink 1J, the space for releasing the heat increases, and the heat can be released over a wider range, thereby enabling achieving further enhancement in the cooling efficiency.

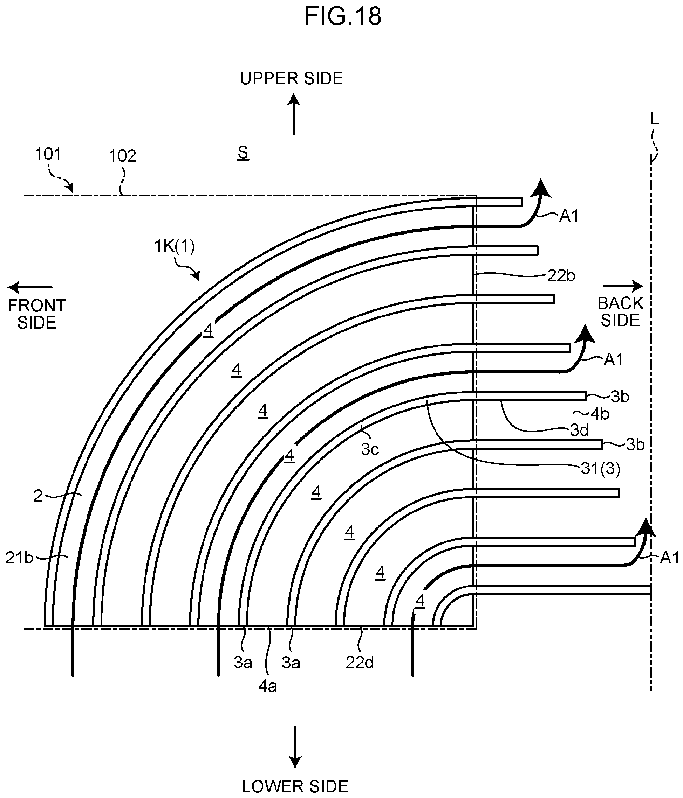

In the heat sink 1K illustrated in FIG. 18, each first-type fin 31 includes the extended portion 3d because of which the other end portion 3b extends in the horizontal direction from the posterior end 22b of the base 2 to the outside of the range of the other surface 21b of the base 2 (i.e., toward the back side). Thus, the extended portion 3d is placed to extend in the horizontal direction. In the heat sink 1K, the first-type fins 31 are arranged in such a way that, because of the extended portions 3d, the corresponding other end portions 3b, which have extended to the outside of the range of the other surface 21b of the base 2 (i.e., extended more on the back side than the posterior end 22b of the base 2), become gradually shorter from the lower side to the upper side with respect to the vertical line L, with the lowermost first-type fin 31 serving as the reference.

In the heat sink 1K, the heat generated by the heating element 104 of the electronic device 101 is transferred to the base 2 and is then transferred from the base 2 to the fins 3. In the heat sink 1K, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1K enables preventing a situation in which the heat builds up in the gap S present above the electronic device 101, and enables achieving enhancement in the cooling efficiency.

Moreover, in the heat sink 1K, the other end portions 3b of the first-type fins 31, which constitute the other end portions 4b of the passage portions 4 on the outside of the range of the other surface 21b of the base 2, are formed to extend along the horizontal direction. Hence, the heat liberated from the passage portions 4 positioned in between the first-type fins 31 is guided to the outside of the range of the other surface 21b of the base 2. Furthermore, in the heat sink 1K, regarding the other end portions 3b of the first-type fins 31 protruding more on the back side than the posterior end 22b of the base 2, the end surfaces become exposed from the portion joined at the other surface 21b of the base 2. Hence, the heat gets transferred from the heating element 104 and can be released at a position separated from the base 2 that is at a high temperature. Moreover, in the heat sink 1K, the heat can be released also from the side of the end surface that is separated from the base 2 and that is in the exposed state. As a result, in the heat sink 1K, the space for releasing the heat increases, and the heat can be released over a wider range, thereby enabling achieving further enhancement in the cooling efficiency.

Furthermore, in the heat sink 1K, the first-type fins 31 are arranged in such a way that, because of the extended portions 3d, the corresponding other end portions 3b, which have extended to the outside of the range of the other surface 21b of the base 2 (i.e., extended more on the back side than the posterior end 22b of the base 2), become gradually shorter from the lower side to the upper side with respect to the vertical line L, with the lowermost first-type fin 31 serving as the reference. Hence, the heat liberated from the passage portions 4 positioned in between the first-type fins 31 moves upward without being obstructed by the first-type fins 31 on the upper side. As a result, in the heat sink 1K, the heat can be released over a wider range, thereby enabling achieving further enhancement in the cooling efficiency.

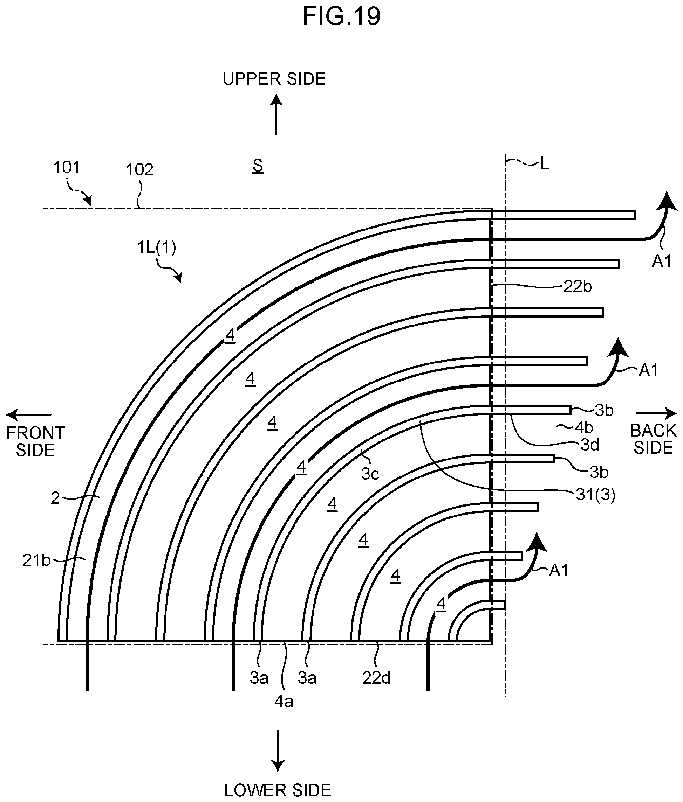

In the heat sink 1L illustrated in FIG. 19, each first-type fin 31 includes the extended portion 3d because of which the other end portion 3b extends in the horizontal direction from the posterior end 22b of the base 2 to the outside of the range of the other surface 21b of the base 2 (i.e., toward the back side). Thus, the extended portion 3d is placed to extend in the horizontal direction. In the heat sink 1L, the first-type fins 31 are arranged in such a way that, because of the extended portions 3d, the corresponding other end portions 3b, which have extended to the outside of the range of the other surface 21b of the base 2 (i.e., extended more on the back side than the posterior end 22b of the base 2), become gradually longer from the lower side to the upper side with respect to the vertical line L, with the lowermost first-type fin 31 serving as the reference.

In the heat sink 1L, the heat generated by the heating element 104 of the electronic device 101 is transferred to the base 2 and is then transferred from the base 2 to the fins 3. In the heat sink 1L, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1L enables preventing a situation in which the heat builds up in the gap S present above the electronic device 101, and enables achieving enhancement in the cooling efficiency.

Moreover, in the heat sink 1L, the other end portions 3b of the first-type fins 31, which constitute the other end portions 4b of the passage portions 4 on the outside of the range of the other surface 21b of the base 2, are formed to extend along the horizontal direction. Hence, the heat liberated from the passage portions 4 positioned in between the first-type fins 31 is guided to the outside of the range of the other surface 21b of the base 2. Furthermore, in the heat sink 1L, regarding the other end portions 3b of the first-type fins 31 protruding more on the back side than the posterior end 22b of the base 2, the end surfaces become exposed from the portion joined at the other surface 21b of the base 2. Hence, the heat gets transferred from the heating element 104 and can be released at a position separated from the base 2 that is at a high temperature. Moreover, in the heat sink 1L, the heat can be released also from the side of the end surface that is separated from the base 2 and that is in the exposed state. As a result, in the heat sink 1L, the space for releasing the heat increases, and the heat can be released over a wider range, thereby enabling achieving further enhancement in the cooling efficiency.

Furthermore, in the heat sink 1L, the first-type fins 31 are arranged in such a way that, because of the extended portions 3d, the corresponding other end portions 3b, which have extended to the outside of the range of the other surface 21b of the base 2 (i.e., extended more on the back side than the posterior end 22b of the base 2), become gradually longer from the lower side to the upper side with respect to the vertical line L, with the lowermost first-type fin 31 serving as the reference. Hence, the upward movement of the heat liberated from the passage portions 4, which are positioned in between the first-type fins 31, is held down by the first-type fins 31 on the upper side. As a result, the heat sink 1L enables holding down the heat release into the gap S present above the main body unit 102 of the electronic device 101, and enables achieving further enhancement in the cooling efficiency.

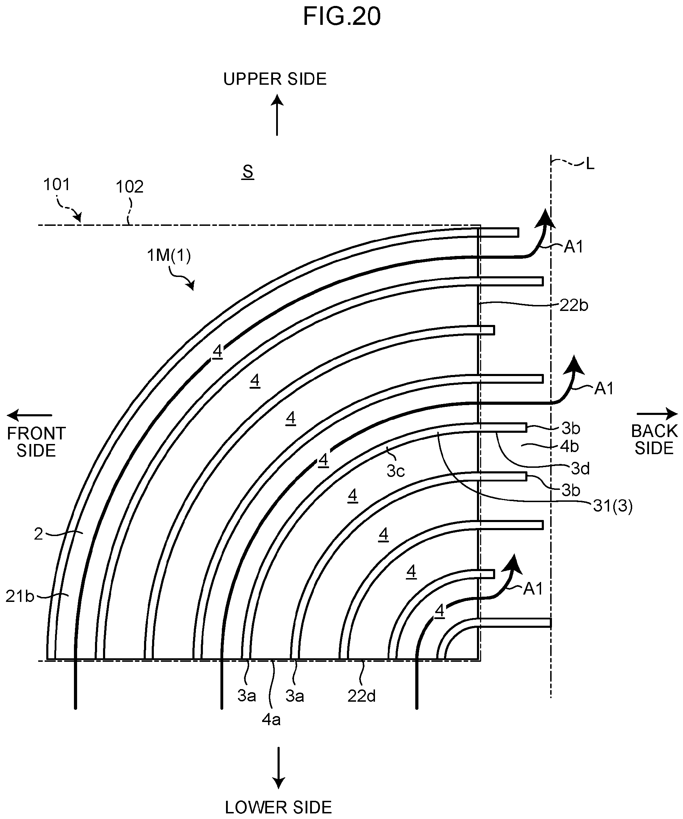

In the heat sink 1M illustrated in FIG. 20, each first-type fin 31 includes the extended portion 3d because of which the other end portion 3b extends in the horizontal direction from the posterior end 22b of the base 2 to the outside of the range of the other surface 21b of the base 2 (i.e., toward the back side). Thus, the extended portion 3d is placed to extend in the horizontal direction. In the heat sink 1M, the first-type fins 31 are arranged in such a way that, because of the extended portions 3d, the corresponding other end portions 3b, which have extended to the outside of the range of the other surface 21b of the base 2 (i.e., extended more on the back side than the posterior end 22b of the base 2), are arranged in an uneven manner with respect to the vertical line L.

In the heat sink 1M, the heat generated by the heating element 104 of the electronic device 101 is transferred to the base 2 and is then transferred from the base 2 to the fins 3. In the heat sink 1M, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1M enables preventing a situation in which the heat builds up in the gap S present above the electronic device 101, and enables achieving enhancement in the cooling efficiency.

Moreover, in the heat sink 1M, the other end portions 3b of the first-type fins 31, which constitute the other end portions 4b of the passage portions 4 on the outside of the range of the other surface 21b of the base 2, are formed to extend along the horizontal direction. Hence, the heat liberated from the passage portions 4 positioned in between the first-type fins 31 is guided to the outside of the range of the other surface 21b of the base 2. As a result, in the heat sink 1M, the heat can be released over a wider range, thereby enabling achieving further enhancement in the cooling efficiency.

Moreover, in the heat sink 1M, because of the extended portions 3d, the corresponding other end portions 3b, which have extended to the outside of the range of the other surface 21b of the base 2 (i.e., extended more on the back side than the posterior end 22b of the base 2), are arranged in an uneven manner with respect to the vertical line L. Hence, regarding the heat liberated from the passage portions 4 positioned in between the first-type fins 31, the upward movement occurs without being obstructed by the first-type fins 31 on the upper side as well as the upward movement is held down by the first-type fins 31 on the upper side. As a result, the heat sink 1M produces the effect of enabling heat release in a wider range as well as produces the effect of enabling holding down the heat release into the gap S present above the main body unit 102 of the electronic device 101, and thus enables achieving further enhancement in the cooling efficiency.

The heat sink 1 according to the second embodiment is characterized by including: the base 2 having the plate-like one surface 21a attached along the outer surface of the right plate 102f representing an upright wall portion of the main body unit 102 of the electronic device 101; a plurality of fins 3 arranged side by side along the plate-like other surface 21b of the base 2; and the passage portions 4 that are formed in between the fins 3 and in a continuous manner along the other surface 21b of the base 2. In the state in which the base 2 is attached to the right plate 102f, the fins 3 are formed in such a way that the one end portions 4a of the passage portions 4 are left open toward the lower side along the vertical direction and that the other end portions 4b of all passage portions 4 are positioned on the upper side with respect to the one end portions 4a and are left open along the horizontal direction. On the outside of the range of the other surface 21b of the base 2, the other end portions 3b of the fins 31 on the side of the other end portion of the passage portions 4 are formed to extend along the horizontal direction.

In the heat sink 1, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, the heat sink 1 enables preventing a situation in which the heat builds up in the gap S present above the electronic device 101, and enables achieving enhancement in the cooling efficiency.

Moreover, in the heat sink 1, on the outside of the range of the other surface 21b of the base 2, the other end portions of the fins 31 constituting the other end portions 4b of the passage portions 4 are formed to extend along the horizontal direction. Hence, the heat liberated from the passage portions 4 positioned in between the fins 31 is guided to the outside of the range of the other surface 21b of the base 2. As a result, in the heat sink 1, the heat can be released over a wider range, thereby enabling achieving further enhancement in the cooling efficiency.

Furthermore, in the heat sink 1 according to the second embodiment, in the fins 3, the other end portions 3b that are extended to the outside of the range of the other surface 21b of the base 2 are arranged to become gradually shorter from the lower side to the upper side with respect to the vertical line L, with the lowermost fin 3 serving as the reference.

Thus, in the heat sink 1, the heat liberated from the passage portions 4 positioned in between the fins 3 moves upward without being obstructed by the fins 3 on the upper side. As a result, in the heat sink 1, the heat can be released over a wider range, thereby enabling achieving further enhancement in the cooling efficiency.

Moreover, in the heat sink 1 according to the second embodiment, in the fins 3, the other end portions 3b that are extended to the outside of the range of the other surface 21b of the base 2 are arranged to become gradually longer from the lower side to the upper side with respect to the vertical line L, with the lowermost fin 3 serving as the reference.

Thus, in the heat sink 1, regarding the heat liberated from the passage portions 4 positioned in between the fins 3, the upward movement is held down by the fins 3 on the upper side. As a result, the heat sink 1 enables holding down the heat release into the gap S present above the main body unit 102 of the electronic device 101, and enables achieving further enhancement in the cooling efficiency.

Moreover, in the heat sink 1 according to the second embodiment, in the fins 3, the other end portions 3b that are extended to the outside of the range of the other surface 21b of the base 2 are arranged in an uneven manner with respect to the vertical line L.

Thus, in the heat sink 1, regarding the heat liberated from the passage portions 4 positioned in between the fins 3, the upward movement occurs without being obstructed by the fins 3 on the upper side as well as the upward movement is held down by the fins 3 on the upper side. As a result, the heat sink 1 produces the effect of enabling heat release in a wider range as well as produces the effect of enabling holding down the heat release into the gap S present above the main body unit 102 of the electronic device 101, and thus enables achieving further enhancement in the cooling efficiency.

In the electronic device 101 according to the second embodiment, the heat sink 1 explained above is used.

Thus, the electronic device 101 enables preventing a situation in which the heat builds up in the gap S present above, and enables achieving enhancement in the cooling efficiency. Moreover, since the heat can be released over a wider range, it becomes possible to achieve further enhancement in the cooling efficiency.

Meanwhile, the heat sink 1 according to the second embodiment can include the characteristics of the heat sink 1 according to the first embodiment, and enables achieving the effects based on the characteristics of the first embodiment.

The second embodiment described above includes the following inventions.

[Invention 1]

A heat sink including:

a base that has a plate-like one surface attached to outer surface of an upright wall portion of an electronic device;
a plurality of fins arranged side by side along a plate-like other surface of the base; and
passage portions that are formed in between the fins and in a continuous manner along the other surface of the base, wherein
in a state in which the base is attached to the upright wall portion, the fins are formed in such a way that one end portions of the passage portions are left open toward lower side along vertical direction and that other end portions of all of the passage portions are positioned on upper side with respect to the one end portions and are left open along horizontal direction, and

outside of range of the other surface of the base, end portions of the fins on side of the other end portions of the passage portions are formed to extend along with horizontal direction.

[Invention 2]

The heat sink according to invention 1, wherein the fins are arranged in such a way that the end portions which have extended to outside of range of the other surface of the base become gradually shorter from lower side to upper side with respect to a vertical line, with lowermost of the fins serving as reference.

[Invention 3]

The heat sink according to invention 1, wherein the fins are arranged in such a way that the end portions which have extended to outside of range of the other surface of the base become gradually longer from lower side to upper side with respect to a vertical line, with lowermost of the fins serving as reference.

[Invention 4]

The heat sink according to invention 1, wherein the fins are arranged in such a way that the end portions which have extended to outside of range of the other surface of the base are arranged in an uneven manner with respect to a vertical line.

[Invention 5]

An electronic device including:

a device main body in which

a heating element is disposed on inner surface of a predetermined upright wall portion, and
a plate member is placed above upper lateral wall portion to which upper end of the predetermined upright wall portion is connected; and

the heat sink according to any one of inventions 1 to 4.

[Third embodiment of heat sink]

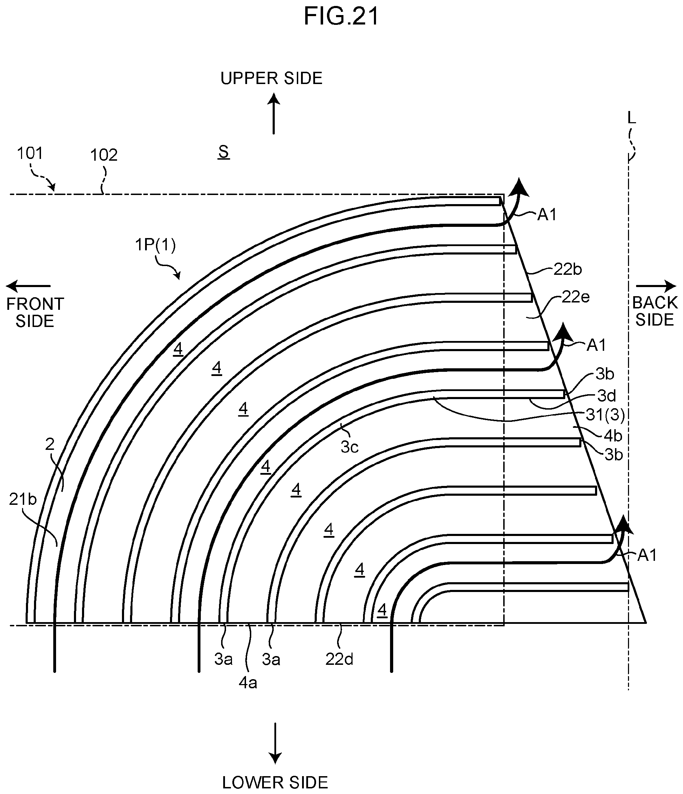

Regarding the heat sink 1 according to a third embodiment, the detailed explanation is given below with reference to FIG. 21. In FIG. 21 is illustrated the state in which the heat sink 1 is attached to the right plate 102f representing an upright wall portion.

In a heat sink 1P according to a third embodiment, the shape of the fins 3 is identical to the shape of the fins 3 according to the second embodiment. Herein, equivalent constituent elements are referred to by the same reference numerals, and their explanation is not given in a repeated manner.

In the heat sink 1P, the base 2 is formed to include an extended portion 22e that is formed when, in the heat sink 1K, the posterior end 22b extends up to the other end portion 2b while including the extended portions 3d of the first-type fins 31. Accordingly, along with the extended portions 3d of the first-type fins 31, the extended portion 22e of the base 2 is arranged to protrude more to the back side than the back plate 102b of the main body unit 102 of the electronic device 101. In the heat sinks 1J, 1K, 1L, and 1M explained above, only the extended portions 3d of the first-type fins 31 are arranged to protrude more to the back side than the back plate 102b of the main body unit 102 of the electronic device 101.

In the heat sink 1P, the heat generated by the heating element 104 of the electronic device 101 is transferred to the base 2 and is then transferred from the base 2 to the fins 3. In the heat sink 1P, due to the heat transferred to the fins 3, the air A1 that is present in the passage portions 4 formed in between the fins 3 moves upward and flows from the one end portions 4a, which are positioned on the lower side, toward the other end portions 4b, which are positioned on the upper side; and is liberated to the back side toward which the other end portions 4b are oriented and which is more on the back side than the back plate 102b of the main body unit 102 of the electronic device 101. As a result, in an identical manner to the heat sink 1A, the heat sink 1P enables preventing a situation in which the heat builds up in the gap S present above the electronic device 101, and enables achieving enhancement in the cooling efficiency.

Moreover, in the heat sink 1P, since the other end portions 3b of the first-type fins 31 that constitute the other end portions 4b of the passage portions 4 are formed to extend along the horizontal direction, the heat liberated from the passage portions 4 positioned in between the first-type fins 31 is guided to the outside of the range of the other surface 21b of the base 2. Furthermore, in the heat sink 1P, along with the extended portions 3d (the posterior end portion 3b) of the first-type fins 31, the extended portion 22e (the posterior end 22b) of the base 2 is arranged to protrude more to the back side than the back plate 102b of the main body unit 102 of the electronic device 101. Hence, the heat is guided more to the back side than the back plate 102b of the main body unit 102.

Moreover, in the heat sink 1P, the other end portions 3b of the first-type fins 31 are arranged to become gradually shorter from the lower side to the upper side with respect to the vertical line L, with the lowermost first-type fin 31 serving as the reference. Hence, the heat liberated from the passage portions 4 positioned in between the first-type fins 31 moves upward without being obstructed by the first-type fins 31 on the upper side. As a result, in the heat sink 1P, when viewed along the vertical line L, the heat can be released over a wider range, thereby enabling achieving further enhancement in the cooling efficiency.

[Other configurations]

In the heat sinks 1A to 1M explained above, in an identical manner to the heat sink 1P, along with the posterior end portion 3b of the first-type fins 31, the posterior end 22b of the base 2 can be placed to protrude more to the back side than the back plate 102b of the main body unit 102 of the electronic device 101.

[Working example]

Given below is the explanation about a performance test performed regarding heat sinks according to a working example.

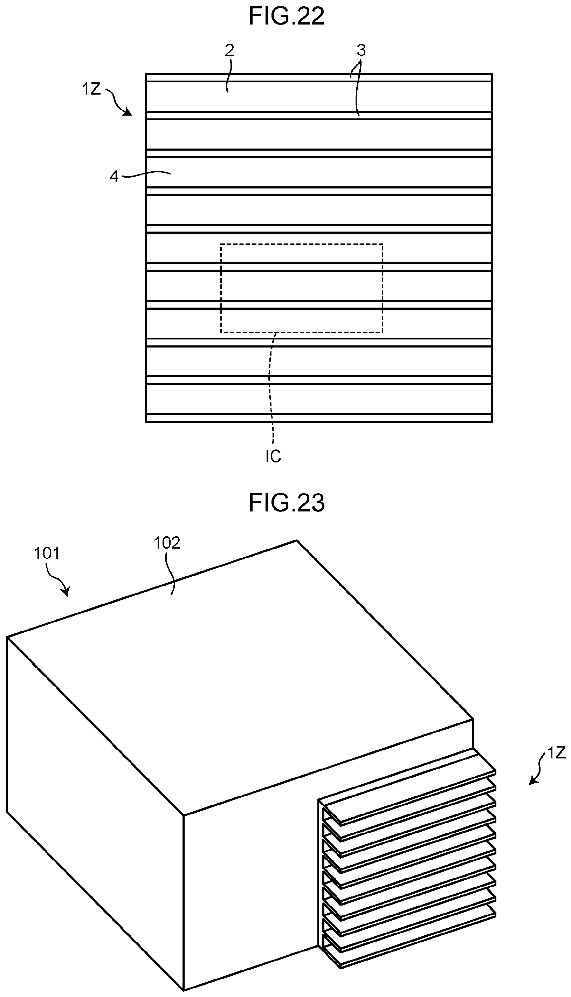

The performance test was performed based on a simulation using the finite element method. More particularly, the performance test was performed to evaluate models from a model 1 to model 5, which are illustrated in FIGS. 22, 26, 30, 34, and 38, based on the temperature attained by the heat generated in a power IC (IC). The term power IC is a collective term for integrated circuits having a power semiconductor built-in.

In the simulation, the main body unit 102 of the electronic device 101 was hollowed out; a power IC (IC) was disposed inside the main body unit 102; and, with the power IC kept exposed from the main body unit 102, the base 2 of each heat sink model from the model 1 to the model 5 was brought into contact with the power IC. Then, during the simulation, a calorific value of 20 W was applied to the power IC at the room temperature of 25° C, and heating was performed till temperature saturation was achieved. Regarding the result of the performance test, the shapes of the heat sink models from the model 1 to the model 5 were treated as the parameter, and comparative study was performed about the difference in the rise in temperature of the power ICs and the state of the air flow around the heat sinks. In the simulation analysis, natural convection was assumed to have occurred, and the turbulent flow was not taken into account. Moreover, regarding the heat transfer path, the heat transfer and the radiation was taken into account.

The material of the power IC (IC) was assumed to be a commonly-used packaging material such as a resin (beryllium oxide). Moreover, the material of the main body unit 102 of the electronic device 101 was assumed to be a resin (polycarbonate). As a result of using a resin for the main body unit 102, almost all of the heat of the power IC (IC) could be transferred to the heat sink, and the evaluation was approximated to the case of using only the heat sink.

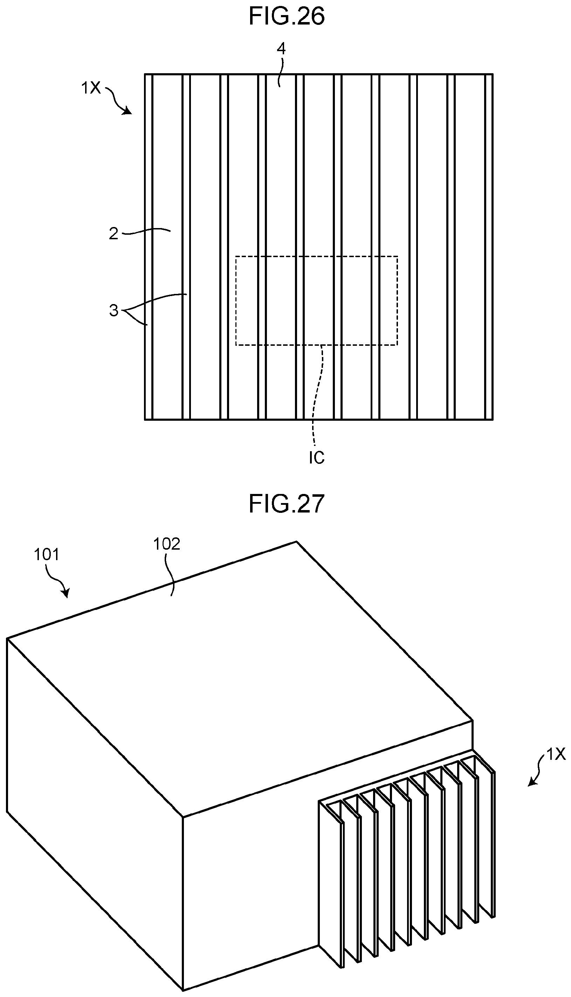

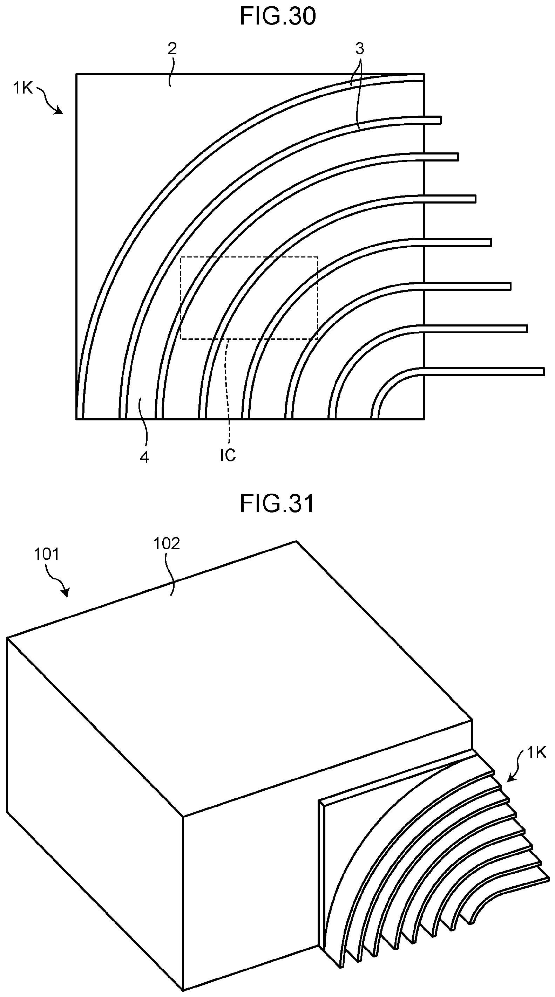

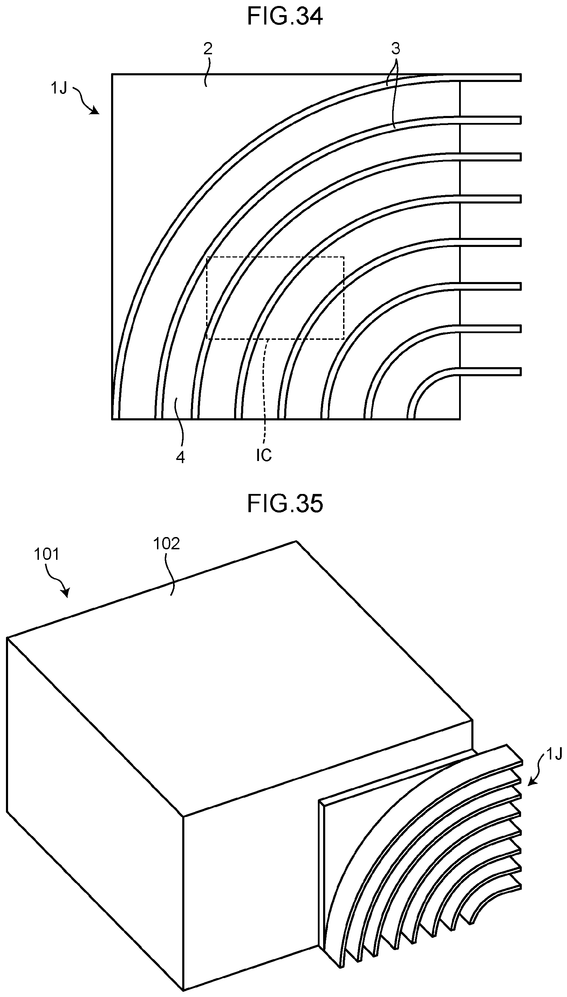

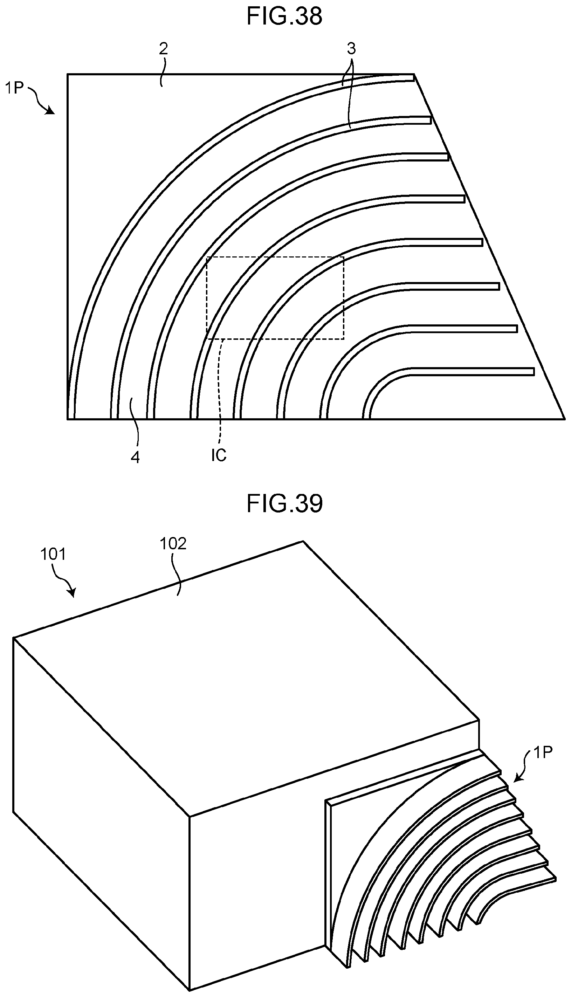

The model 1 corresponds to the heat sink 1Z explained earlier (see FIGS. 22 and 23). The model 2 corresponds to the heat sink 1X explained earlier (see FIGS. 26 and 27). The model 3 corresponds to the heat sink 1K explained earlier (see FIGS. 30 and 31). The model 4 corresponds to the heat sink 1J explained earlier (see FIGS. 34 and 35). The model 5 corresponds to the heat sink 1P explained earlier (FIGS. 38 and 39). Herein, it is assumed that aluminum is used as the material of the heat sinks.

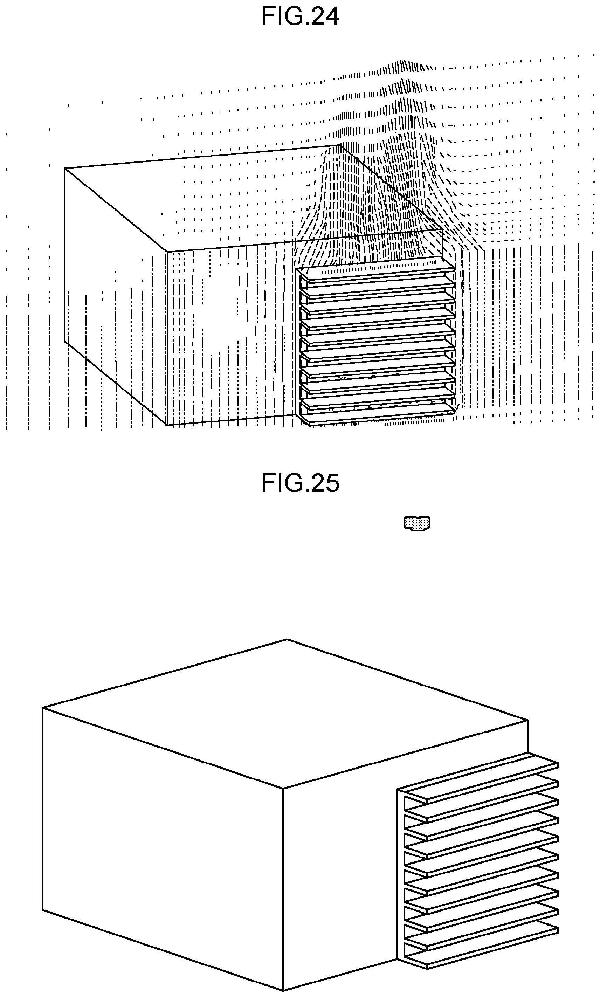

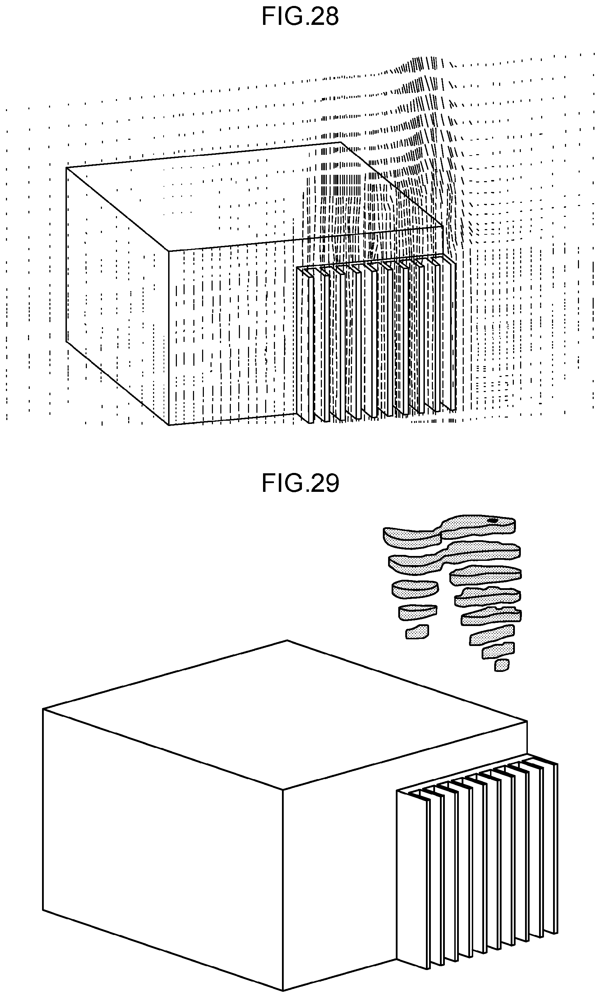

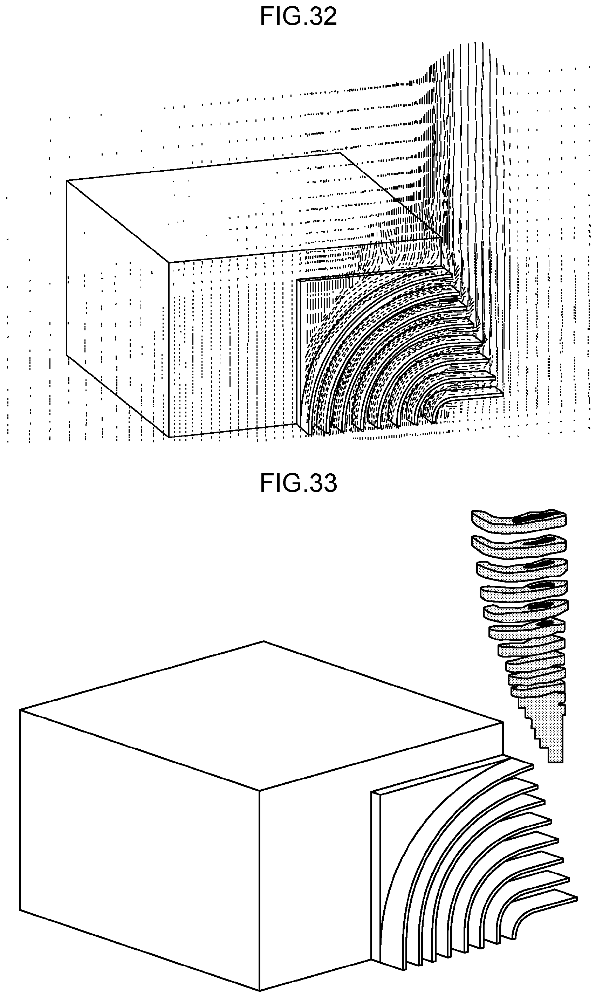

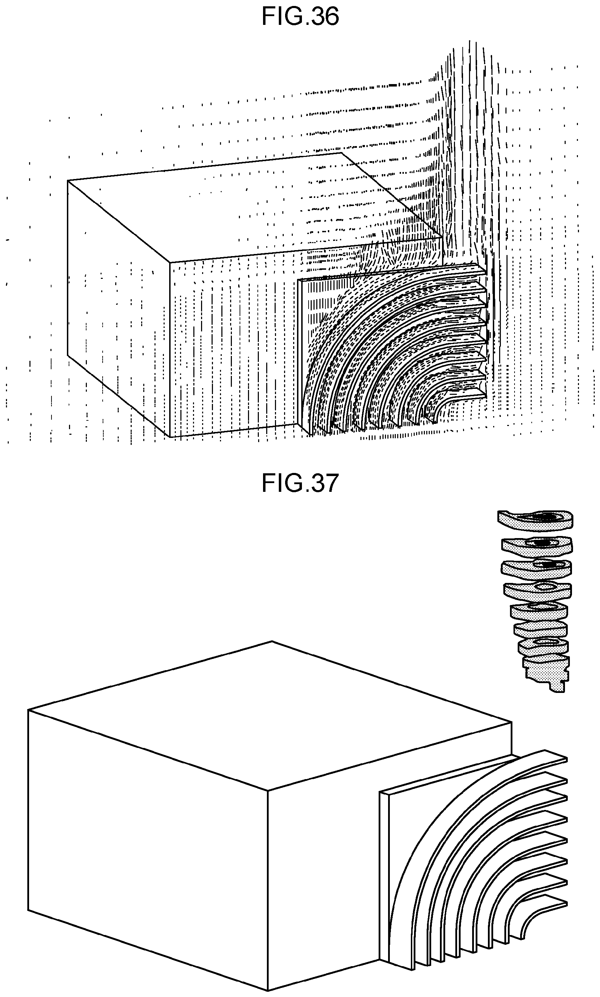

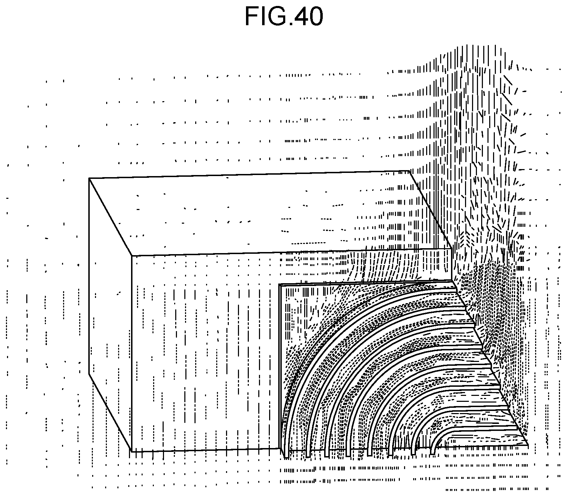

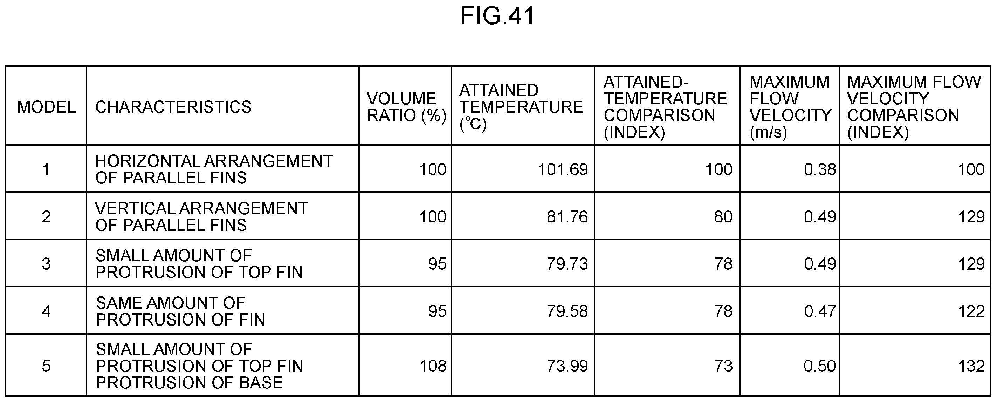

As the evaluation, regarding the model 1, with reference to FIG. 24, small line segments oriented in various directions indicate the state of the air flow around the heat sink, and indicate the maximum flow velocity zone in FIG. 25. Regarding the model 2, with reference to FIG. 28, small line segments oriented in various directions indicate the state of the air flow around the heat sink, and indicate the maximum flow velocity zone in FIG. 29. Regarding the model 3, with reference to FIG. 32, small line segments oriented in various directions indicate the state of the air flow around the heat sink, and indicate the maximum flow velocity zone in FIG. 33. Regarding the model 4, with reference to FIG. 36, small line segments oriented in various directions indicate the state of the air flow around the heat sink, and indicate the maximum flow velocity zone in FIG. 37. Regarding the model 5, with reference to FIG. 40, small line segments oriented in various directions indicate the state of the air flow around the heat sink. In FIG. 41 is illustrated the volume ratio (with the model 1 being treated as the baseline 100%); the attained temperature (°C) at the contact surface between the power IC and the heat sink; the attained-temperature comparison (with the model 1 being treated as the baseline 100%); the maximum flow velocity around the heat sink (m/s); and the maximum flow velocity comparison (with the model 1 being treated as the baseline 100%).

The small line segments oriented in various directions as illustrated in FIGS. 24, 28, 32, 36, and 40 indicate the directions of the air flow for each element in a finite element model in which the zone of the air is divided into a cubic lattice structure. The maximum flow velocity zone illustrated in each of FIGS. 25, 29, 33, and 37 indicates the zone in which, from among a countless number of elements of the finite element model of the air, the flow velocity is equal to or greater than a threshold value. Essentially, in the space, the uniform flow velocity surface is supposed to be a curved surface. However, since the three-dimensional shape is complex, it becomes difficult to understand the shape of the zone on the plane of the paper. In order to make it easy to understand, that zone is displayed by separating it in the up-down direction. Moreover, since the numerical scale of the flow velocity (i.e., the maximum flow velocity and the minimum flow velocity) is illustrated in a standardized form in the drawings, it becomes possible to compare the results of different models. Meanwhile, in FIGS. 29, 33, and 37, the blacked-out portions indicate the maximum flow velocity points in the maximum flow velocity zone.

As compared to the models 1 and 2, since the models 3 to 5 had a greater maximum flow velocity occurring around the corresponding heat sinks, the evaluation result indicated that the heat of the power IC was discharged to the outside and there was a drop in the attained temperature of the power IC.

In the model 1, since the exits (the other end portions 4b) of the passage portions 4 are arranged side by side in the horizontal direction, the heated air immediately spreads in the space above the heat sink. In the models 3 to 5, the exits (the other end portions 4b) of the passage portions 4 have the fins overlapped in the gravity direction (the vertical direction), the heated air becomes dense, moves upward at a high velocity while maintaining a high temperature, and hence the stack effect gets enhanced. Moreover, as is the case in the models 3 to 5, when the exits (the other end portions 4b) of the passage portions 4 are formed in a stepwise manner based on the differences in the length of the extended portions of the fins, the flow velocity distribution becomes dense and the upward-moving heated air increases in width. Hence, there is hardly any effect of the cooling due to the outside air, and the buoyancy becomes hard to lose thereby further enhancing the stack effect. As a result, the heated air moves up with a higher flow velocity.

Herein, since the air present in between the fins is drawn out because of the negative pressure attributed to the upward movement of the heated air in the vicinity of the other end portions 3b of the fins, the heat release from the heat sink is incredibly weak. On the other hand, the heated air moves upward due to the buoyant force. When the heat source is on the lower side, there is a decrease in the low-temperature air that obstructs the upward movement of the heated air. Hence, there is further increase in the buoyancy due to the stack effect. That is, in the models 3 to 5, the upward-moving air has a high flow velocity because of the upward movement attributed to the buoyancy of the heated air in the vicinity of the other end portions 3b of the fins.

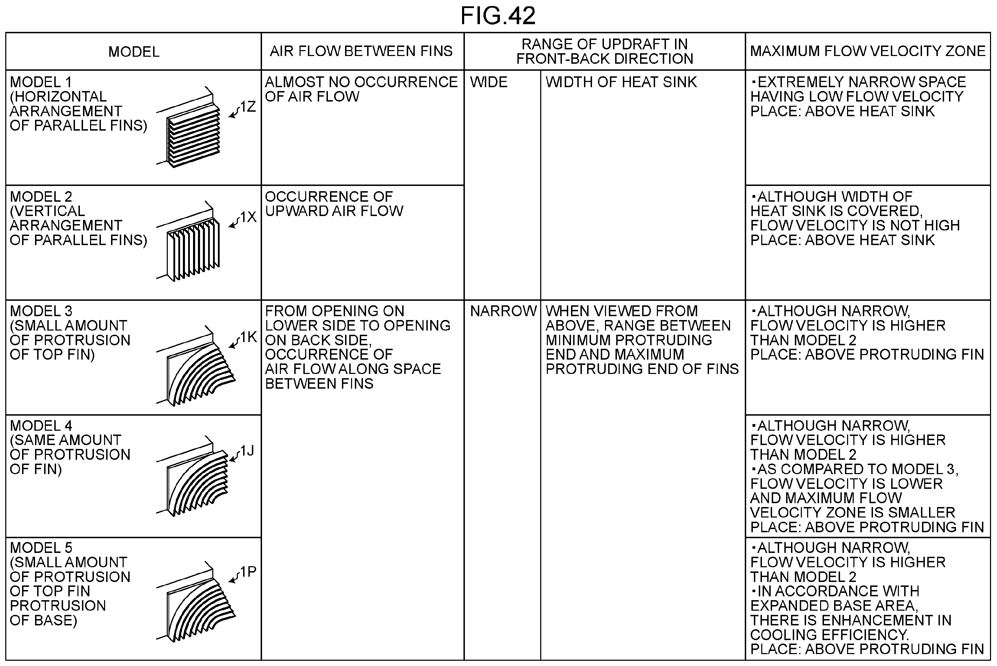

FIG. 42 is a chart illustrating the evaluation of each model subjected to the performance test of heat sinks according to the working example.

In the performance test of heat sinks as explained above, when the model 1 is compared with the model 2, the points of occurrence of the updraft at the width of the heat sinks are common and their range is relatively wide. In the model 2, the air present in between the fins is likely to flow to the upper side thereby resulting in the updraft, and the overhead maximum flow velocity value is also large.

In the performance test of heat sinks as explained above, as compared to the models 1 and 2, in the models 3 to 5, when viewed from above, the updraft occurs in the range between the minimum protruding end and the maximum protruding end of the fins, and that range is relatively narrow. In the model 3, as compared to the model 2, the flow velocity is higher at the upper side of the protruding fins. In the model 4, as compared to the model 2, the flow velocity is higher at the upper side of the protruding fins. However, in the model 4, as compared to the model 3, the flow velocity and the maximum flow velocity is lower. In the model 5, as compared to the model 2, the flow velocity is higher at the upper side of the protruding fins. In the model 5, in accordance with the expanded base area, there is enhancement in the cooling efficiency. Meanwhile, as is the case of the models 3 and 5, when the amount of protrusion of the fins gradually changes in the up-down direction, as compared to the model 4 in which the amount of protrusion of the fins remains same in the up-down direction, the range of the maximum flow velocity points is larger in the maximum flow velocity zone, and the cooling efficiency is excellent.

Industrial Applicability

The application concerned enables achieving enhancement in the cooling efficiency.

Reference Signs List

1(1A,1B,1C,1D,1E,1F,1G,1H,1I,1J,1K, 1L,1M,1N,1P)    heat sink
2    base

| 21a | one surface |
| 21b | other surface |
| 3 | fin (31 first-type fin) |
| 3a | one end portion |
| 3b | other end portion |
| 3d | extended portion |
| 4 | passage portion |
| 4a | one end portion |
| 4b | other end portion |
| 101 | electronic device |
| 102 | main body unit |
| 104 | heating element |
| L | vertical line |

**Claims**

1. A heat sink comprising:

a base that has a plate-like one surface attached to outer surface of an upright wall portion of an electronic device;
a plurality of fins arranged side by side along a plate-like other surface of the base; and
passage portions that are formed in between the fins and in a continuous manner along the other surface of the base, wherein
in a state in which the base is attached to the upright wall portion, the fins are formed in such a way that one end portions of the passage portions are left open toward lower side along vertical direction and that other end portions of all of the passage portions are positioned on upper side with respect to the one end portions and are left open along horizontal direction.

2. The heat sink according to claim 1, wherein, on outside of range of the other surface of the base, end portions of the fins on side of the other end portions of the passage portions are formed to extend along horizontal direction.

3. The heat sink according to claim 1, wherein, between the fins neighboring each other, interval changes in such a way that the one end portion of the corresponding passage portion is greater than the other end portion.

4. The heat sink according to claim 1, wherein the fins are formed in a curved manner in such a way that the passage portions bulge upward.

5. The heat sink according to claim 1, wherein, within range of other surface of the base, end portions of the fins constituting the other end portions of the passage portions have different positions with respect to a vertical line.

6. The heat sink according to claim 2, wherein, in the fins, the end portions formed to extend to outside of range of the other surface of the base are arranged to become gradually shorter from lower side to upper side with respect to a vertical line, with lowermost of the fins serving as reference.

7. The heat sink according to claim 2, wherein, in the fins, the end portions formed to extend to outside of range of the other surface of the base are arranged to become gradually longer from lower side to upper side with respect to a vertical line, with lowermost of the fins serving as reference.

8. The heat sink according to claim 2, wherein, in the fins, the end portions formed to extend to outside of range of the other surface of the base are arranged in an uneven manner with respect to a vertical line.

9. An electronic device comprising:

a device main body in which

a heating element is disposed on inner surface of a predetermined upright wall portion, and
a plate member is placed above upper lateral wall portion to which upper end of the predetermined upright wall portion is connected; and

a heat sink that is attached to outer surface of the upright wall portion of the device main body, wherein the heat sink includes

a base that has a plate-like one surface attached to outer surface of the upright wall portion, a plurality of fins arranged side by side along a plate-like other surface of the base, and passage portions that are formed in between the fins and in a continuous manner along the other surface of the base, and

in a state in which the base is attached to the upright wall portion, the fins are formed in such a way that one end portions of the passage portions are left open toward lower side along vertical direction and that other end portions of all of the passage portions are positioned on upper side with respect to the one end portions and are left open along horizontal direction.

10. The electronic device according to claim 9, wherein, in the heat sink, on outside of range of the other surface of the base, end portions of the fins on side of the other end portions of the passage portions are formed to extend along horizontal direction.

# FIG.1

UPPER SIDE

LEFT SIDE

FRONT SIDE

RIGHT SIDE

BACK SIDE

LOWER SIDE

101

103

102

102c

102e

102a

102f

3

1

2

4

104

102b

102d

# FIG.2

UPPER SIDE

LEFT SIDE

FRONT SIDE

BACK SIDE

RIGHT SIDE

LOWER SIDE

1A(1)

21a

2 22c

21b

32(3)

22a

3c

32(3)

3a

3c

3a

4a 4

22d

3b

31(3)

31(3)

3b

31(3)

22b

31(3)

4b

31(3)

31(3)

31(3)

31(3)

# FIG.3

UPPER SIDE

FRONT SIDE

BACK SIDE

LOWER SIDE

# FIG.4

# FIG.5

# FIG.6

# FIG.7

UPPER SIDE

FRONT SIDE

BACK SIDE

LOWER SIDE

101
102
S
31(3)
3b
1B(1)
4b
3b
4b
22c
3b
A1
4b
31(3)
3b
4b
3c
A1
3b
4b
4
22b
4
3b
21b
4
4b
4
3b
4
4b
4
31(3)
4
3b
4
4b
4
3b

3a
4a
3a
4a
2
3a
4a
3a
4a
3a
4a
3a
4a
3a
4a
3a
22d
3a
4a
3a
4a

# FIG.8

UPPER SIDE

FRONT SIDE

BACK SIDE

LOWER SIDE

# FIG.9

# FIG.10

# FIG.11

UPPER SIDE

T∞

S,Tw

3

$\lambda a$

$\delta$

LOWER SIDE

# FIG.12

UPPER SIDE

101

102

S

A1

1E(1)

31(3)

3b

3c

4b    B2

3b

FRONT
SIDE

BACK
SIDE

4

4

4

A1

4

22b

4

2

4

21b

4

4

3a    4a    3a    22d

B1

LOWER SIDE

# FIG.13

# FIG.14

UPPER SIDE

↑

S

L

101
102

1G(1)

← FRONT SIDE

A1

22b

A1

31(3)
3b
4b
3b

3c

BACK SIDE →

2

21b

4

4

4

4

4

4

4

4

4

4

4

3a  3a  22d
4a

↓

LOWER SIDE

# FIG.15

UPPER SIDE

S

101  102

L

1H(1)

A1

22b

FRONT
SIDE

4

4

4

A1

3b
4b

BACK
SIDE

31(3)

3c

3b

2

4

4

21b

4

4

A1

4

3a ( 3a     22d

4a

LOWER SIDE

# FIG.16

UPPER SIDE

S — L

101    102

1I(1)

A1

22b

FRONT
SIDE

BACK
SIDE

A1

4

4

4

3b
4b

31(3)

4

3c    3b

2

4

21b    4

4

A1

4

4

3a    3a    22d

4a

LOWER SIDE

# FIG.17

# FIG.18

UPPER SIDE

101  102  S

1K(1)

FRONT
SIDE

BACK
SIDE

A1

22b

A1

3b
~4b
3d
3b
31(3)

4

4

4

4

4

4

4

4

3c

2

21b

A1

3a  3a  22d
4a

LOWER SIDE

# FIG.19

UPPER SIDE

↑

FRONT SIDE ←

→ BACK SIDE

↓

LOWER SIDE

# FIG.20

UPPER SIDE

S

101 102

1M(1)

L

A1

22b

4

4

4

A1

FRONT SIDE

BACK SIDE

3b
4b
3d
3b

3c

31(3)

4

4

2

4

21b

4

A1

4

3a 3a

4a

22d

LOWER SIDE

# FIG.21

UPPER SIDE

S

101

102

1P(1)

FRONT SIDE

4

4

4

4

4

4

4

4

4

4

2

21b

3a

3a

4a

22d

22b

22e

A1

3b

3d

31(3)

4b

3b

3c

BACK SIDE

L

A1

A1

LOWER SIDE

## FIG.22

## FIG.23

## FIG.24

## FIG.25

## FIG.26

## FIG.27

# FIG.28

# FIG.29

## FIG.30

## FIG.31

# FIG.32

# FIG.33

## FIG.34

## FIG.35

## FIG.36

## FIG.37

## FIG.38

## FIG.39

FIG.40

## FIG.41

| MODEL | CHARACTERISTICS | VOLUME RATIO (%) | ATTAINED TEMPERATURE (°C) | ATTAINED-TEMPERATURE COMPARISON (INDEX) | MAXIMUM FLOW VELOCITY (m/s) | MAXIMUM FLOW VELOCITY COMPARISON (INDEX) |
|---|---|---|---|---|---|---|
| 1 | HORIZONTAL ARRANGEMENT OF PARALLEL FINS | 100 | 101.69 | 100 | 0.38 | 100 |
| 2 | VERTICAL ARRANGEMENT OF PARALLEL FINS | 100 | 81.76 | 80 | 0.49 | 129 |
| 3 | SMALL AMOUNT OF PROTRUSION OF TOP FIN | 95 | 79.73 | 78 | 0.49 | 129 |
| 4 | SAME AMOUNT OF PROTRUSION OF FIN | 95 | 79.58 | 78 | 0.47 | 122 |
| 5 | SMALL AMOUNT OF PROTRUSION OF TOP FIN PROTRUSION OF BASE | 108 | 73.99 | 73 | 0.50 | 132 |

EP 4 750 236 A1

## FIG.42

| MODEL | AIR FLOW BETWEEN FINS | RANGE OF UPDRAFT IN FRONT-BACK DIRECTION | | MAXIMUM FLOW VELOCITY ZONE |
|---|---|---|---|---|
| MODEL 1 (HORIZONTAL ARRANGEMENT OF PARALLEL FINS) 1Z | ALMOST NO OCCURRENCE OF AIR FLOW | WIDE | WIDTH OF HEAT SINK | ·EXTREMELY NARROW SPACE HAVING LOW FLOW VELOCITY PLACE: ABOVE HEAT SINK |
| MODEL 2 (VERTICAL ARRANGEMENT OF PARALLEL FINS) 1X | OCCURRENCE OF UPWARD AIR FLOW | | | ·ALTHOUGH WIDTH OF HEAT SINK IS COVERED, FLOW VELOCITY IS NOT HIGH PLACE: ABOVE HEAT SINK |
| MODEL 3 (SMALL AMOUNT OF PROTRUSION OF TOP FIN) 1K | FROM OPENING ON LOWER SIDE TO OPENING ON BACK SIDE, OCCURRENCE OF AIR FLOW ALONG SPACE BETWEEN FINS | NARROW | WHEN VIEWED FROM ABOVE, RANGE BETWEEN MINIMUM PROTRUDING END AND MAXIMUM PROTRUDING END OF FINS | ·ALTHOUGH NARROW, FLOW VELOCITY IS HIGHER THAN MODEL 2 PLACE: ABOVE PROTRUDING FIN |
| MODEL 4 (SAME AMOUNT OF PROTRUSION OF FIN) 1J | | | | ·ALTHOUGH NARROW, FLOW VELOCITY IS HIGHER THAN MODEL 2 ·AS COMPARED TO MODEL 3, FLOW VELOCITY IS LOWER AND MAXIMUM FLOW VELOCITY ZONE IS SMALLER PLACE: ABOVE PROTRUDING FIN |
| MODEL 5 (SMALL AMOUNT OF PROTRUSION OF TOP FIN PROTRUSION OF BASE) 1P | | | | ·ALTHOUGH NARROW, FLOW VELOCITY IS HIGHER THAN MODEL 2 ·IN ACCORDANCE WITH EXPANDED BASE AREA, THERE IS ENHANCEMENT IN COOLING EFFICIENCY. PLACE: ABOVE PROTRUDING FIN |

EP 4 750 236 A1

## INTERNATIONAL SEARCH REPORT

International application No.

**PCT/JP2024/027140**

### A. CLASSIFICATION OF SUBJECT MATTER

*H05K 7/20*(2006.01)i; *F28F 1/18*(2006.01)i
FI: H05K7/20 B; F28F1/18

According to International Patent Classification (IPC) or to both national classification and IPC

### B. FIELDS SEARCHED

Minimum documentation searched (classification system followed by classification symbols)

H05K7/20; F28F1/18

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2015-059995 A (JVC KENWOOD CORP.) 30 March 2015 (2015-03-30) paragraphs [0010]-[0050], fig. 1-9 | 1-5, 9-10 |
| A | paragraphs [0010]-[0050], fig. 1-9 | 6-8 |
| Y | US 6847525 B1 (UNISYS CORPORATION) 25 January 2005 (2005-01-25) column 4, line 30 to column 5, line 18, fig. 3-4 | 1-5, 9-10 |
| Y | US 2008/0151505 A1 (FOXCONN TECHNOLOGY CO., LTD.) 26 June 2008 (2008-06-26) paragraphs [0014]-[0021], fig. 1-3 | 1-5, 9-10 |
| Y | US 2004/0246676 A1 (BARR, Andrew Harvey) 09 December 2004 (2004-12-09) paragraphs [0024]-[0036], fig. 2 | 2, 10 |
| A | JP 3075726 U (MUUNTOLAITE OY) 06 November 2001 (2001-11-06) entire text, all drawings | 1-10 |
| A | JP 2019-092337 A (MITSUBISHI ELECTRIC CORPORATION) 13 June 2019 (2019-06-13) entire text, all drawings | 1-10 |

☐ Further documents are listed in the continuation of Box C.   ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **15 August 2024** | **03 September 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

| International application No. |
| :--- |
| **PCT/JP2024/027140** |

| Patent document<br>cited in search report | | | Publication date<br>(day/month/year) | Patent family member(s) | Publication date<br>(day/month/year) |
| :--- | :--- | :--- | :--- | :--- | :--- |
| JP | 2015-059995 | A | 30 March 2015 | (Family: none) | |
| US | 6847525 | B1 | 25 January 2005 | (Family: none) | |
| US | 2008/0151505 | A1 | 26 June 2008 | (Family: none) | |
| US | 2004/0246676 | A1 | 09 December 2004 | (Family: none) | |
| JP | 3075726 | U | 06 November 2001 | US 6313399 B1<br>entire text, all drawings<br>WO 1999/027761 A1<br>CN 2443582 Y | |
| JP | 2019-092337 | A | 13 June 2019 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019092337 A